# EUROPEAN PATENT APPLICATION

(11) **EP 4 645 395 A1**
(43) Date of publication of application: **05.11.2025**
(21) Application number: 23912048.8
(22) Date of filing: 25.12.2023
(51) Int. Cl.: H01L 31/042, E06B 5/00, H02J 7/00, H02J 7/35, H02S 10/20, H02S 20/26, H02S 30/00, H02S 30/10, H02S 40/30, H10K 30/40, H10K 39/12

(54) **SOLAR POWER GENERATION SYSTEM**

(30) Priority: 27.12.2022 JP 2022210952
(71) Applicant: Panasonic Intellectual Property Management Co., Ltd., Kadoma-shi, Osaka 571-0057 (JP)
(72) Inventor: SEKIMOTO, Takeyuki, Kadoma-shi, Osaka 571-0057 (JP)
(74) Representative: Grünecker Patent- und Rechtsanwälte PartG mbB
(86) International application number: PCT/JP2023/046410
(87) International publication number: WO 2024/143268

(57) **Abstract**

A photovoltaic power generation system (100) includes a first structure (110) and a second structure (120). The first structure (110) includes a plurality of first photoelectric conversion bodies (111). The second structure (120) includes at least one second photoelectric conversion body (121). The first photoelectric conversion bodies (111) each extend in a first direction (151) as a length direction. A direction in which the first photoelectric conversion bodies (111) are aligned is a second direction (152) that is orthogonal to the first direction (151). When viewed from a third direction (153) that is orthogonal to both the first direction (151) and the second direction (152), at least part of the at least one second photoelectric conversion body (121) is configured to overlap with at least part of the first photoelectric conversion bodies (111).

## Description

### TECHNICAL FIELD

The present invention relates to a photovoltaic power generation system.

### BACKGROUND ART

Photovoltaic power generation is known as a power generation method. Photovoltaic power generation is performed using a photoelectric conversion body.

Patent Literature 1 describes a photovoltaic power generation system that has a substrate and a photoelectric conversion body supported by the substrate. The substrate is formed by using at least part of glass for window.

### CITATION LIST

### Patent Literature

Patent Literature 1: JP H4-360983 A
Patent Literature 2: WO2020/208854

### SUMMARY OF INVENTION

### Technical Problem

The present disclosure provides a technique suitable for securing electric power generated by a photovoltaic power generation system.

### Solution to Problem

The present disclosure provides a photovoltaic power generation system including:
a first structure including a plurality of first photoelectric conversion bodies; and
a second structure including at least one second photoelectric conversion body, wherein
the first photoelectric conversion bodies each extend in a first direction as a length direction of the first photoelectric conversion body;
a direction in which the first photoelectric conversion bodies are aligned is a second direction that is orthogonal to the first direction; and
when viewed from a third direction that is orthogonal to both the first direction and the second direction, at least part of the at least one second photoelectric conversion body is formed to overlap with at least part of the first photoelectric conversion bodies.

### Advantageous Effects of Invention

The technique according to the present disclosure is suitable for securing electric power generated by a photovoltaic power generation system.

### BRIEF DESCRIPTION OF DRAWINGS

FIG. 1A is an explanatory diagram of a photovoltaic power generation system according to Embodiment 1.
FIG. 1B is an explanatory diagram of the photovoltaic power generation system according to Embodiment 1.
FIG. 1C is an explanatory diagram of the photovoltaic power generation system according to Embodiment 1.
FIG. 2A is a diagram of a photovoltaic power generation system according to Embodiment 1, viewed from an orthogonal direction.
FIG. 2B is a diagram of the photovoltaic power generation system according to Embodiment 1, viewed from the orthogonal direction.
FIG. 3 is a cross-sectional view of a photovoltaic power generation system according to Embodiment 1.
FIG. 4 is an explanatory diagram of an arrangement of a plurality of first photoelectric conversion bodies.
FIG. 5 is an explanatory diagram of an electrical connection of a plurality of first photoelectric conversion bodies.
FIG. 6 is an explanatory diagram of an arrangement of a plurality of second photoelectric conversion bodies.
FIG. 7 is an explanatory diagram of an electrical connection of a plurality of second photoelectric conversion bodies.
FIG. 8A is a plan view of a first configuration example where an integrated solar cell module is used.
FIG. 8B is a cross-sectional view of the first configuration example where an integrated solar cell module is used.
FIG. 8C is an explanatory diagram of a damage avoidance function of a first configuration example.
FIG. 9A is a plan view of a second configuration example where an integrated solar cell module is used.
FIG. 9B is a cross-sectional view of a second configuration example where an integrated solar cell module is used.
FIG. 9C is a cross-sectional view of a second configuration example where an integrated solar cell module is used.
FIG. 9D is a cross-sectional view of a second configuration example where an integrated solar cell module is used.
FIG. 9E is an explanatory diagram of an electrical connection of light-absorbing layers in a second configuration example.
FIG. 9F is an explanatory diagram of a damage avoidance function of a second configuration example.
FIG. 10A is a plan view of a third configuration example where an integrated solar cell module is used.
FIG. 10B is a cross-sectional view of the integrated solar cell module shown in FIG. 10A, a cross section being taken along a line XB-XB and viewed in a direction indicated with a pair of arrows.
FIG. 10C is a cross-sectional view of a cross-sectional configuration of the third configuration example, the cross section corresponding to FIG. 9D.
FIG. 11A is a cross-sectional view of a cross-sectional configuration of a fourth configuration example, the cross section corresponding to FIG. 9C and FIG. 10B.
FIG. 11B is a cross-sectional view of a cross-sectional configuration of a fourth configuration example, the cross section corresponding to FIG. 9D and FIG. 10C.
FIG. 12A is a cross-sectional view of a cross-sectional configuration of a fifth configuration example, the cross section corresponding to FIG. 9C, FIG. 10B, and FIG. 11A.
FIG. 12B is a cross-sectional view of a cross-sectional configuration of the fifth configuration example, the cross section corresponding to FIG. 9D, FIG. 10C, and FIG. 11B.
FIG. 12C is an explanatory diagram of an electrical connection of light-absorbing layers in the fifth configuration example.
FIG. 12D is an explanatory diagram of an alignment of a designated structure in a fifth configuration example.
FIG. 13 is an explanatory diagram of an electrical system of a photovoltaic power generation system.
FIG. 14A is a diagram of a photovoltaic power generation system according to Embodiment 2, viewed from an orthogonal direction.
FIG. 14B is a diagram of a photovoltaic power generation system according to Embodiment 2, viewed from an orthogonal direction.
FIG. 15 is a cross-sectional view of a photovoltaic power generation system according to Embodiment 2.
FIG. 16A is a diagram of a photovoltaic power generation system according to Embodiment 3, viewed from an orthogonal direction.
FIG. 16B is a diagram of a photovoltaic power generation system according to Embodiment 3, viewed from an orthogonal direction.
FIG. 16C is a diagram of a photovoltaic power generation system according to Embodiment 3, viewed from an orthogonal direction.
FIG. 17 is a cross-sectional view of a photovoltaic power generation system according to Embodiment 3.
FIG. 18 is an explanatory diagram of a shape variation of a support frame.
FIG. 19A is an explanatory diagram of a photovoltaic power generation system according to a first reference example.
FIG. 19B is an explanatory diagram of a photovoltaic power generation system according to the first reference example.
FIG. 19C is an explanatory diagram of a photovoltaic power generation system according to the first reference example.

### DESCRIPTION OF EMBODIMENTS

Hereinafter, the present disclosure will be explained based on embodiments, with reference to the attached drawings, though the present disclosure is not limited to the following the embodiments. The drawings are schematic diagrams.

### (Embodiment 1)

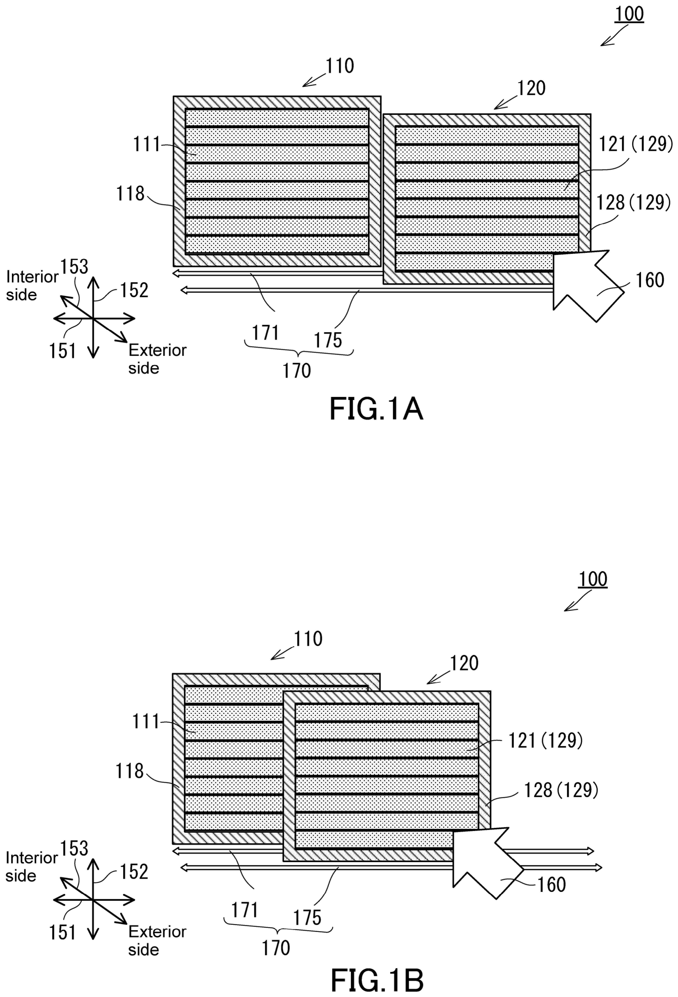

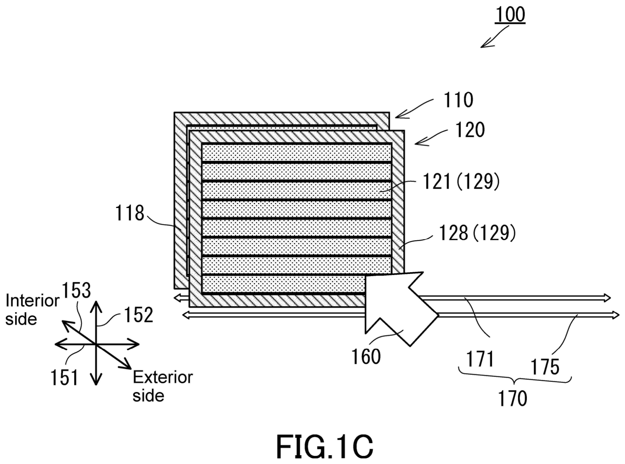

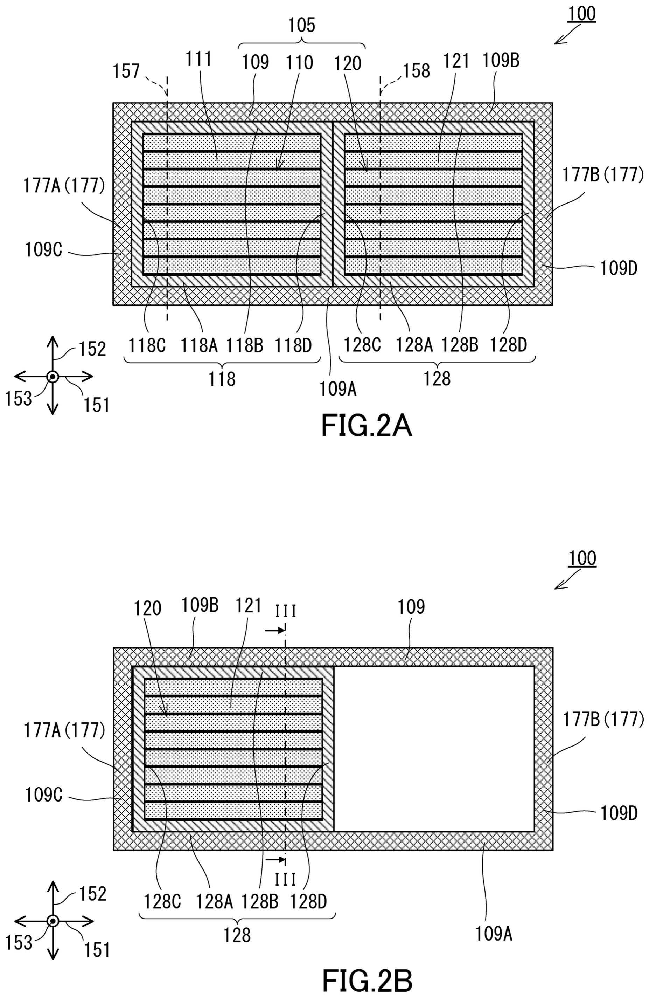

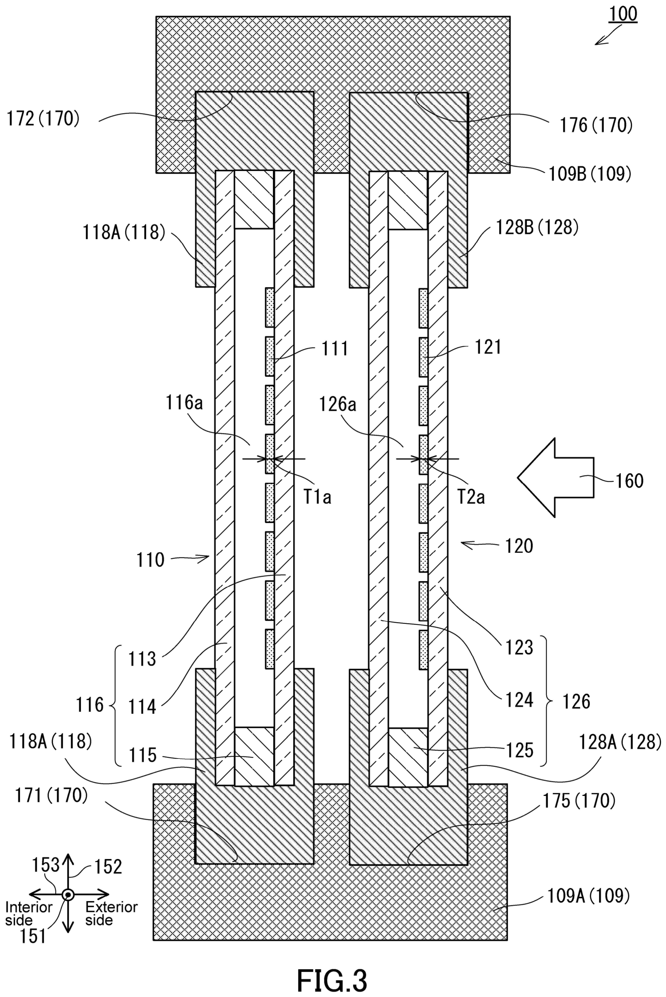

FIG. 1A, FIG. 1B, and FIG. 1C are explanatory diagrams of a photovoltaic power generation system 100 according to Embodiment 1. FIG. 2A and FIG. 2B are diagrams of the photovoltaic power generation system 100 according to Embodiment 1, viewed from an orthogonal direction 153. FIG. 3 is a cross-sectional view of the photovoltaic power generation system 100 according to Embodiment 1. The photovoltaic power generation system 100 includes a window unit 105. Specifically, in FIG. 2A, the window unit 105 is closed. In FIG. 2B, the window unit 105 is open. FIG. 3 is a cross-sectional view of the photovoltaic power generation system 100 shown in FIG. 2B, taken along a line III-III and viewed in a direction indicated with a pair of arrows.

The photovoltaic power generation system 100 includes a first structure 110, a second structure 120, and a guide 170. The guide 170 guides a move of at least one of the first structure 110 and the second structure 120. In Embodiment 1, the first structure 110 is a window, specifically an interior window. The second structure 120 is a window, specifically an exterior window. The guide 170 is provided on a window frame 109. The window unit 105 includes the first structure 110, the second structure 120, and the window frame 109. A sliding window is configured for the window unit 105 of the present embodiment. An arrow 160 indicates a direction of light (specifically, sunlight) incidence. In the present Description, the term "window" refers to a member to be installed in an opening. The "window" may be a fitting. The "window" may be shaped as a board. The "window" may be light-transmissive. The "window" may be movable or immovable. The "window" may include, for example, glass, resin, or the like.

In FIG. 1A to FIG. 3, a transverse direction (first direction) 151, a longitudinal direction (second direction) 152, and an orthogonal direction (third direction) 153 are shown. The transverse direction 151, the longitudinal direction 152, and the orthogonal direction 153 are mutually orthogonal directions. In Embodiment 1, the transverse direction 151 is a direction for opening/closing the window unit 105. The window unit 105 is opened and closed by moving at least one selected from the group consisting of the first structure 110 and the second structure 120 in the transverse direction 151. The orthogonal direction 153 is a direction from the exterior to the interior or from the interior to the exterior.

In the present Description, "orthogonal" does not necessarily mean that the formed angle is exactly 90°. In the present Description, an angle of 85° or more and 95° or less is regarded as "orthogonal".

The terms "transverse direction (first direction) 151", "longitudinal direction (second direction) 152" and "orthogonal direction (third direction) 153" simply express a relative relationship. The transverse direction (first direction) 151 may be the horizontal direction or the vertical direction. The longitudinal direction (second direction) 152 may be the vertical direction or the horizontal direction. Here, the vertical direction is the direction of gravity. This holds true for all of the Embodiments 1 to 3 described below.

In Embodiment 1, the second structure 120 is disposed closer to the light (specifically, sunlight) incident side than the first structure 110. The first structure 110 is disposed closer to the interior side than the second structure 120, and the second structure 120 is disposed closer to the exterior side than the first structure 110. The first structure 110 and the second structure 120 are disposed at positions different from each other along the orthogonal direction 153.

The first structure 110 includes a plurality of first photoelectric conversion bodies 111. The first photoelectric conversion bodies 111 each are, for example, configured using all or part of one or a plurality of integrated solar cell modules. The second structure 120 includes a plurality of second photoelectric conversion bodies 121. The second photoelectric conversion bodies 121 each are, for example, configured using all or part of one or a plurality of integrated solar cell modules. The number of the second photoelectric conversion bodies 121 in the second structure 120 may be one. The second structure may be a window screen ("amido" in Japanese) or a storm shutter ("amado" in Japanese). A solar cell module is an assembly that includes a plurality of elements for performing photovoltaic power generation. The elements include, for example, a plurality of photoelectric conversion elements. The light-absorbing layer 23 may correspond to the photoelectric conversion element in this context.

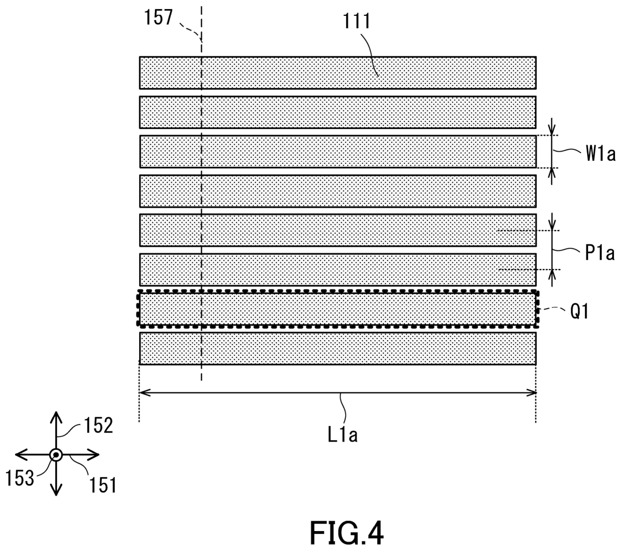

FIG. 4 is an explanatory diagram of an arrangement of the first photoelectric conversion bodies 111. The first photoelectric conversion bodies 111 each extend in the transverse direction 151 as the length direction of the first photoelectric conversion body 111. A direction in which the first photoelectric conversion bodies 111 are aligned is the longitudinal direction 152. Among the first photoelectric conversion bodies 111, two adjacent first photoelectric conversion bodies 111 each have regions that face each other with respect to the longitudinal direction 152. In the present embodiment, when viewed from the orthogonal direction 153, the first photoelectric conversion bodies 111 are disposed such that a first virtual straight line 157 extending in the longitudinal direction 152 intersects with the first photoelectric conversion bodies 111. The number of the first photoelectric conversion bodies 111 is, for example, 2 or more and 50 or less, or may be 5 or more and 30 or less. Here, "when viewed from the orthogonal direction 153" means "when viewed through along the orthogonal direction 153".

The following description refers to the expression that the first photoelectric conversion body 111 extends in the transverse direction 151 as the length direction of the first photoelectric conversion body 111. A rectangle defined as a first evaluation rectangle Q1 is the smallest rectangle that can accommodate the first photoelectric conversion body 111 when viewed from the orthogonal direction 153, as shown in FIG. 4, and it is a rectangle having sides extending in the transverse direction 151 and sides extending in the longitudinal direction 152. In the above expression, that is, "the first photoelectric conversion body 111 extends in the transverse direction 151 as the length direction of the first photoelectric conversion body 111", the term "length direction" refers to the long side direction of the first evaluation rectangle Q1. In the above expression, "extend" refers to "extend continuously or intermittently". The first photoelectric conversion body 111 may be rounded, and even in such a case, the above explanation is still valid.

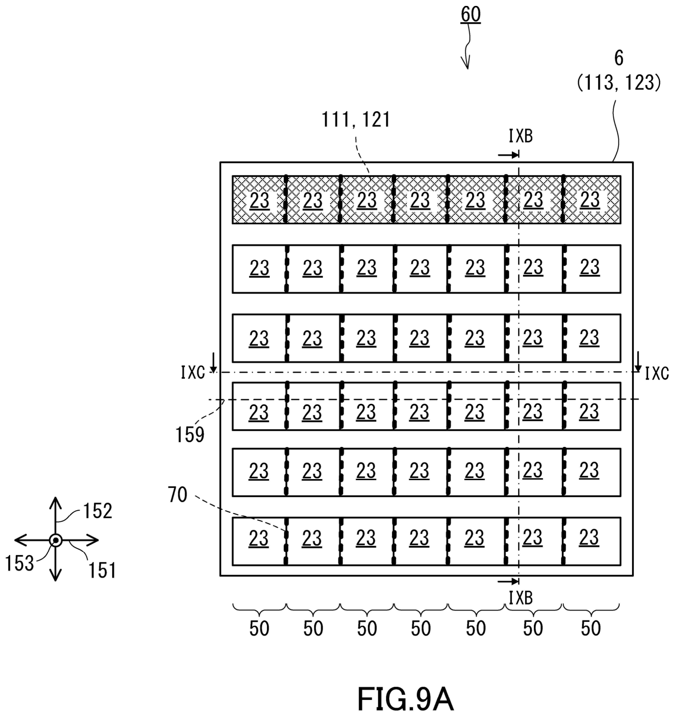

The following description refers to the expression that "the first photoelectric conversion body 111 extends intermittently in the transverse direction 151 as the length direction of the first photoelectric conversion body 111". This expression encompasses the following cases:
- the first photoelectric conversion body 111 includes a plurality of photoelectric conversion elements aligned in the transverse direction 151; when viewed from the orthogonal direction 153, the photoelectric conversion elements each overlap with at least partially with a continuous structure; and, the continuous structure configures at least part of a path electrically connecting the photoelectric conversion elements; and
- the first photoelectric conversion body 111 includes a plurality of photoelectric conversion elements aligned in the transverse direction 151; a plurality of designated structures are aligned in the transverse direction 151; in each of the designated structures, a photoelectric conversion element is disposed between a first electrode and a second electrode with respect to the orthogonal direction 153; and the designated structures adjacent to each other in the transverse direction 151 are divided from each other by a groove. Specific examples of the continuous structure, the designated structure, the first electrode, the second electrode, and the groove are described later with reference to FIG. 9A to FIG. 12D. The light-absorbing layer 23 can correspond to the photoelectric conversion element in this context.

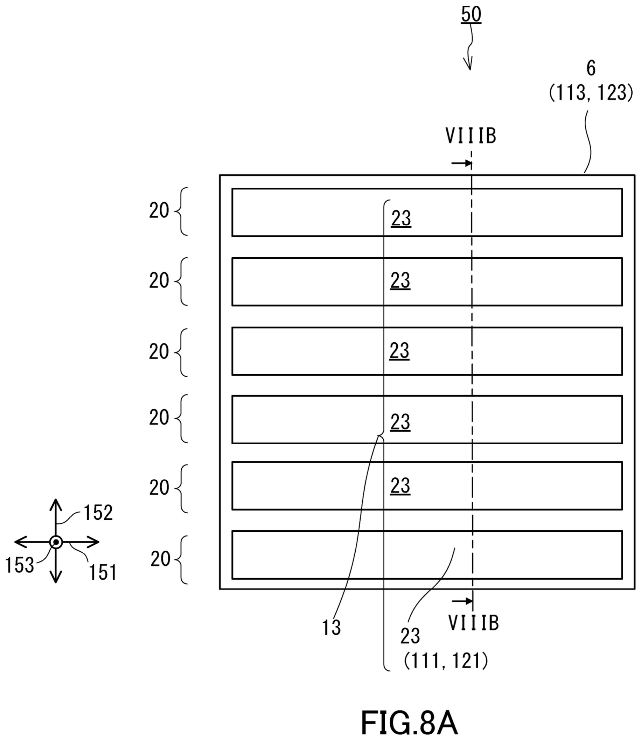

The following description further refers to the expression that the first photoelectric conversion body 111 extends in the transverse direction 151 as the length direction of the first photoelectric conversion body 111. As will be explained later with reference to FIG. 8A to FIG. 12D, the first photoelectric conversion body 111 can be configured using part or all of one or a plurality of the integrated solar cell modules 50. In this case, the transverse direction 151 can be a direction that is orthogonal to the integration direction.

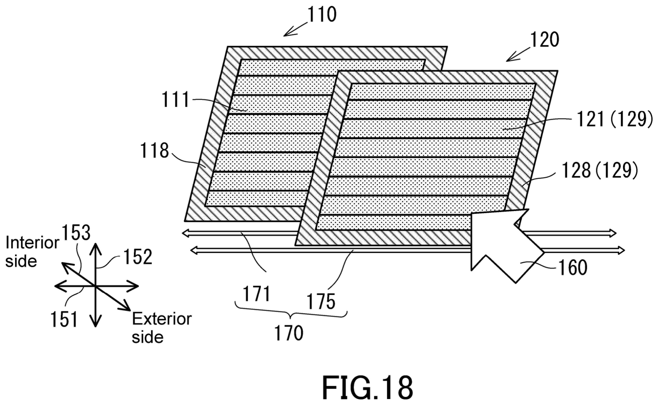

Here, the integration direction is a direction in which a plurality of unit structures are repeatedly aligned. In the example shown in FIG. 8A to FIG. 12D, the integration direction is the longitudinal direction 152. In the example shown in FIG. 8A to FIG. 12D, each unit structure includes a first electrode 26, an electron transport layer 25, a porous layer 24, a light-absorbing layer 23, a hole transport layer 22, and a second electrode 21. Similarly in the case where the embodiment shown in FIG. 8A to FIG. 12D is applied to the configure shown in FIG. 1A, or in the case where the embodiment shown in FIG. 8A to FIG. 12D is applied to the configure shown in FIG. 18, the integration direction is the longitudinal direction 152.

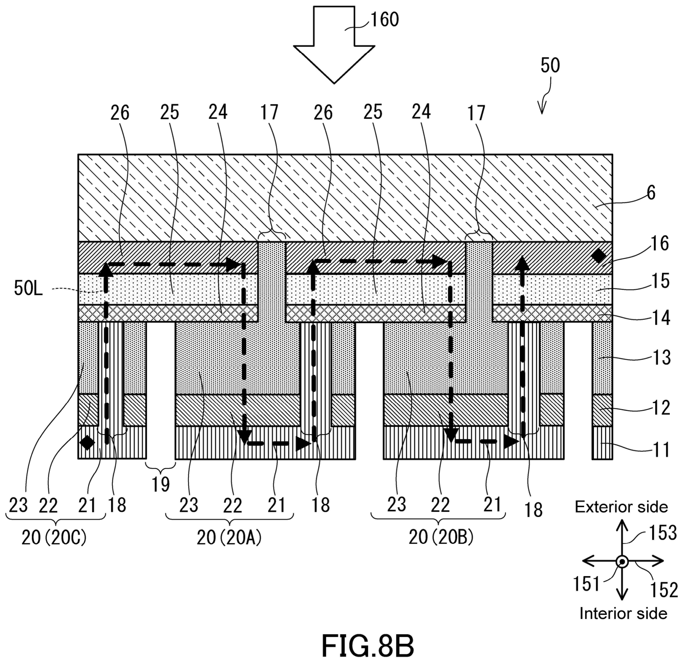

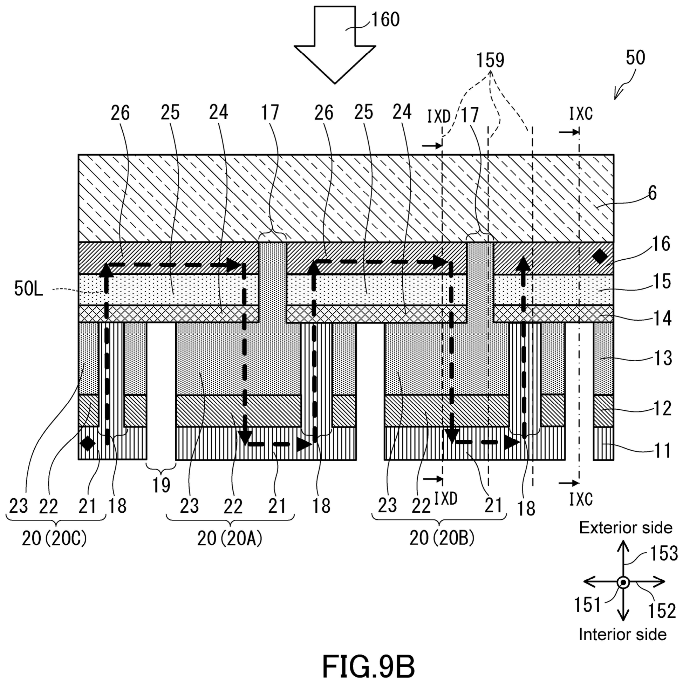

In a plurality of positions different from each other with respect to the transverse direction 151, the structure of the cross-section orthogonal to the transverse direction 151 including a plurality of layers can be the same. In the example shown in FIG. 8A to FIG. 12D, the layers include the first electrode 26, the electron transport layer 25, the porous layer 24, the light-absorbing layer 23, the hole transport layer 22, and the second electrode 21. The structures shown in FIG. 8B and FIG. 9B are specific examples of the cross-sectional structure.

In FIG. 4, a dimension W1a is a dimension of the first photoelectric conversion body 111 in the longitudinal direction 152. A dimension L1a is a dimension of the first photoelectric conversion body 111 in the transverse direction 151. A ratio L1a/W1a of the dimension L1a to the dimension W1a is, for example, 5 or more and 400 or less. The ratio L1a/W1a may be 10 or more and 200 or less.

In FIG. 4, a pitch P1a is a pitch at which the first photoelectric conversion bodies 111 are aligned in the longitudinal direction 152. A ratio W1a/P1a of the dimension W1a to the pitch P1a is, for example, more than 0.5 and 1.0 or less. The ratio W1a/P1a may be 0.8 or more and 1.0 or less. The dimension W1a may be the same as the pitch P1a, or may be smaller than the pitch P1a.

The dimension W1a is, for example, 5 mm or more and 60 mm or less. The dimension W1a may be 10 mm or more and 30 mm or less. The dimension L1a is, for example, 300 mm or more and 4000 mm or less. The dimension L1a may be 600 mm or more and 2000 mm or less. The pitch P1a is, for example, 2.5 mm or more and 60 mm or less. The pitch P1a may be 4 mm or more and 30 mm or less.

In FIG. 3, a dimension T1a is a dimension of the first photoelectric conversion body 111 in the orthogonal direction 153. Specifically, the dimension T1a is a thickness of the first photoelectric conversion body 111. The dimension T1a is, for example, 100 nm or more and 100 µm or less. The lower limit of the range of the dimension T1a may be 200 nm, or may be 500 nm. The upper limit of the range of the dimension T1a may be 10 µm, may be 5 µm, may be 1.5 µm, or may be 1.2 µm.

The first photoelectric conversion bodies 111 are electrically connected in series. The electrical connection is not limited to any particular aspect. In the present embodiment, when viewed from the orthogonal direction 153, the first photoelectric conversion bodies 111 are electrically connected to each other along the longitudinal direction 152. A specific example of the configuration will be explained later, with reference to FIG. 8A and FIG. 8B. Over the entire dimension L1a in the transverse direction 151, each of the first photoelectric conversion bodies 111 may be electrically connected to an adjacent first photoelectric conversion body 111 with respect to the longitudinal direction 152.

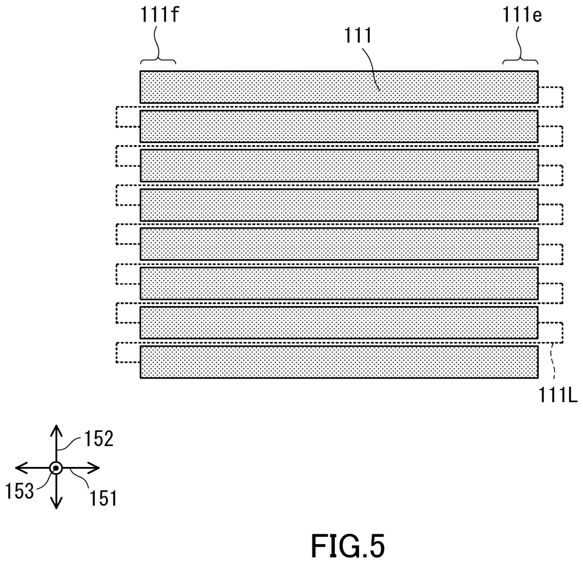

FIG. 5 is an explanatory diagram of a variation of the electrical connection of the first photoelectric conversion bodies 111. In FIG. 5, the electrical connection is shown schematically with a dotted line 111L. The first photoelectric conversion bodies 111 are electrically connected in series. Specifically, each of the first photoelectric conversion bodies 111 includes an end portion 111e and an end portion 111f facing each other in the transverse direction 151. Each of the end portion 111e and the end portion 111f is, for example, a region of the first photoelectric conversion body 111 equally divided into ten divisions in the transverse direction 151. In FIG. 5, as for the first photoelectric conversion bodies 111, the end portion 111e of one of two adjacent first photoelectric conversion bodies 111 is electrically connected to the end portion 111f of the other first photoelectric conversion body 111.

As shown in FIG. 2A, the first structure 110 includes a first support frame 118. The first support frame 118 supports the first photoelectric conversion bodies 111. When viewed from the orthogonal direction 153, the first support frame 118 has a closed frame shape. In the present embodiment, both an inner contour and an outer contour of the closed frame have a shape of rectangle. Here, the term "rectangle" indicates a concept including a square. When viewed from the orthogonal direction 153, at least part of the first photoelectric conversion body 111 is located within the closed frame. In the present embodiment, the entire first photoelectric conversion body 111 is located within this closed frame. The first support frame 118 is made of metal or resin, for example.

The following description refers to the expression "the first support frame 118 supports a plurality of first photoelectric conversion bodies 111". This expression encompasses a form in which the first support frame 118 supports the first photoelectric conversion bodies 111 by contacting with the first photoelectric conversion bodies 111. This expression encompasses also a form in which the first support frame 118 supports the first photoelectric conversion bodies 111 via another member. This holds true also for expressions such as "the second support frame 128 supports at least one second photoelectric conversion body 121", "the first photoelectric conversion bodies 111 ... are supported by the first substrate 113", and "at least one second photoelectric conversion body 121 ... is supported by the third substrate 123". In the present embodiment, as shown in FIG. 3, the first support frame 118 supports the first photoelectric conversion bodies 111 via the first substrate 113.

As shown in FIG. 2A, the first support frame 118 includes a first frame member 118A, a second frame member 118B, a third frame member 118C, and a fourth frame member 118D. The first frame member 118A and the second frame member 118B extend in the transverse direction 151. The first frame member 118A and the second frame member 118B face each other. The third frame member 118C connects the first frame member 118A and the second frame member 118B. The fourth frame member 118D connects the first frame member 118A and the second frame member 118B. The third frame member 118C and the fourth frame member 118D face each other. When viewed from the orthogonal direction 153, the first frame member 118A, the second frame member 118B, the third frame member 118C and the fourth frame member 118D are combined to shape the closed frame as described above. The third frame member 118C and the fourth frame member 118D extend in a direction different from the transverse direction 151, specifically these frame members extend in the longitudinal direction 152.

As shown in FIG. 3, the first structure 110 includes a first substrate 113, a second substrate 114, and a spacer 115. The first substrate 113 is provided on the exterior side. The second substrate 114 is provided on the interior side. The first substrate 113 and the second substrate 114 are made of glass. The spacer 115 has a closed frame shape when viewed from the orthogonal direction 153. A double glazing 116 is configured to include the first substrate 113, the second substrate 114, and the spacer 115. A void layer 116a is provided inside the double glazing 116 partitioned by the first substrate 113, the second substrate 114, and the spacer 115. The void layer 116a is, for example, an air layer. Alternatively, it may be, for example, an argon layer or for example, a layer with a higher degree of vacuum than the outside air. The first photoelectric conversion bodies 111 are disposed inside the void layer 116a and supported by the first substrate 113. The first substrate 113 protects the first photoelectric conversion bodies 111. A specific light transmittance of the first substrate 113 in the orthogonal direction 153 is, for example, 30% or more and less than 100%. A specific light transmittance of the second substrate 114 in the orthogonal direction 153 is, for example, 30% or more and less than 100%. Here, the specific light transmittance refers to the average value of light transmittance in the wavelength range of 400 nm or more and 800 nm or less. The first substrate 113 and the second substrate 114 may be made of resin.

A second structure 120 includes at least one second photoelectric conversion body 121. In the present embodiment, the second structure 120 includes a plurality of second photoelectric conversion bodies 121. The second photoelectric conversion bodies 121 each are, for example, configured using a part or all of one or more of the integrated solar cell modules. As shown in FIG. 3, the second structure 120 includes a third substrate 123, a fourth substrate 124, and a spacer 125. The third substrate 123 is provided on the exterior side. The fourth substrate 124 is provided on the interior side. The third substrate 123 and the fourth substrate 124 are made of glass. A spacer 125 has a shape of a closed frame when viewed from the orthogonal direction 153. A double glazing 126 is configured to include the third substrate 123, the fourth substrate 124 and the spacer 125. A void layer 126a is provided inside the double glazing 126 partitioned by the third substrate 123, the fourth substrate 124 and the spacer 125. The void layer 126a is, for example, an air layer. Alternatively, it may be, for example, an argon layer, or for example, a layer with a higher degree of vacuum than the outside air. The second photoelectric conversion bodies 121 are disposed inside the void layer 126a and are supported by the third substrate 123. The third substrate 123 protects the second photoelectric conversion bodies 121. A specific light transmittance of the third substrate 123 in the orthogonal direction 153 is, for example, 30% or more and less than 100%. A specific light transmittance of the fourth substrate 124 in the orthogonal direction 153 is, for example, 30% or more and less than 100%. The third substrate 123 and the fourth substrate 124 may be made of resin.

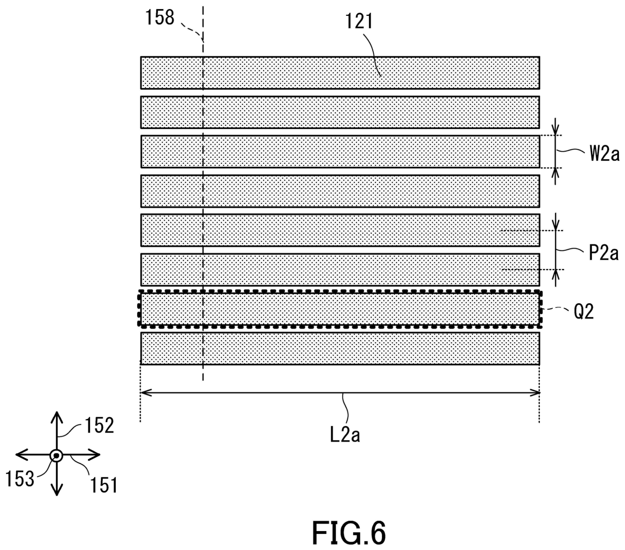

FIG. 6 is an explanatory diagram of an arrangement of the second photoelectric conversion bodies 121. The second photoelectric conversion bodies 121 each extend in the transverse direction 151 as the length direction of the second photoelectric conversion body 121. A direction in which the second photoelectric conversion bodies 121 are aligned is the longitudinal direction 152. Among the second photoelectric conversion bodies 121, two adjacent second photoelectric conversion bodies 121 each have regions that face each other with respect to the longitudinal direction 152. In the present embodiment, the second photoelectric conversion bodies 121 are disposed such that a second virtual straight line 158 extending in the longitudinal direction 152 intersects with the second photoelectric conversion bodies 121 when viewed from the orthogonal direction 153. The number of the second photoelectric conversion bodies 121 is, for example, 2 or more and 50 or less, and may be 5 or more and 30 or less. The number of the second photoelectric conversion bodies 121 may be the same as or may be different from the number of first photoelectric conversion bodies 111.

The following description refers to the expression that the second photoelectric conversion body 121 extends in the transverse direction 151 as the length direction of the second photoelectric conversion body 121. A rectangle defined as a second evaluation rectangle Q2 is the smallest rectangle that can accommodate the second photoelectric conversion body 121 when viewed from the orthogonal direction 153, as shown in FIG. 6, and it is a rectangle having sides extending in the transverse direction 151 and sides extending in the longitudinal direction 152. In the above expression, that is, in "the second photoelectric conversion body 121 extends in the transverse direction 151 as the length direction of the second photoelectric conversion body 121", the term "length direction" refers to the long side direction of the second evaluation rectangle Q2. In the above expression, "extend" refers to "extend continuously or intermittently". The second photoelectric conversion body 121 may be rounded, and in even that case, the explanation is still valid.

The following description relates to the expression that "the second photoelectric conversion body 121 extends intermittently in the transverse direction 151 as the length direction of the second photoelectric conversion body 121". This expression encompasses the following:
- the second photoelectric conversion body 121 includes a plurality of photoelectric conversion elements aligned in the transverse direction 151; when viewed from the orthogonal direction 153, the photoelectric conversion elements each overlap at least partially with the continuous structure; and, the continuous structure configures at least part of a path electrically connecting the photoelectric conversion elements; and
- the second photoelectric conversion body 121 includes a plurality of photoelectric conversion elements aligned in the transverse direction 151; a plurality of designated structures are aligned in the transverse direction 151; in each of the designated structures, a photoelectric conversion element is disposed between the first electrode and the second electrode along the orthogonal direction 153; and, the designated structures adjacent to each other in the transverse direction 151 are divided by a groove. Specific examples of the continuous structure, the designated structure, the first electrode, the second electrode, and the groove are described later with reference to FIG. 9A to FIG. 12D. The light-absorbing layer 23 can correspond to the photoelectric conversion element in this context.

The following description further relates to the expression that the second photoelectric conversion body 121 extends in the transverse direction 151 as the length direction of the second photoelectric conversion body 121. As will be explained later with reference to FIG. 8A to FIG. 12D, the second photoelectric conversion body 121 can be configured using a part or all of one or more of the integrated solar cell modules 50. In this case, the transverse direction 151 can be a direction that is orthogonal to the integration direction.

In FIG. 6, a dimension W2a is a dimension of the second photoelectric conversion body 121 in the longitudinal direction 152. A dimension L2a is a dimension of the second photoelectric conversion body 121 in the transverse direction 151. A ratio L2a/W2a of the dimension L2a to the dimension W2a is, for example, 5 or more and 400 or less. The ratio L2a/W2a may be 10 or more and 200 or less.

In FIG. 6, a pitch P2a is the pitch at which the second photoelectric conversion bodies 121 are aligned in the longitudinal direction 152. A ratio W2a/P2a of the dimension W2a to the pitch P2a is, for example, more than 0.5 and less than 1.0. The ratio W2a/P2a may be 0.8 or more and 1.0 or less. The dimension W2a may be the same as the pitch P2a, or it may be smaller than the pitch P2a.

The dimension W2a is, for example, 5 mm or more and 60 mm or less. The dimension W2a may be 10 mm or more and 30 mm or less. The dimension L2a is, for example, 300 mm or more and 4000 mm or less. The dimension L2a may be 600 mm or more and 2000 mm or less. The pitch P2a is, for example, 2.5 mm or more and 60 mm or less. The pitch P2a may be 4 mm or more and 30 mm or less.

In FIG. 3, a dimension T2a is a dimension of the second photoelectric conversion body 121 in the orthogonal direction 153. Specifically, the dimension T2a is the thickness of the second photoelectric conversion body 121. The dimension T2a is, for example, 100 nm or more and 100 µm or less. The lower limit of the range of the dimension T2a may be 200 nm, or may be 500 nm. The upper limit of the range of the dimension T2a may be 10 µm, may be 5 µm, may be 1.5 µm, or may be 1.2 µm.

The second photoelectric conversion bodies 121 are electrically connected in series. This electrical connection is not limited to any particular aspect. In the present embodiment, when viewed from the orthogonal direction 153, the second photoelectric conversion bodies 121 are electrically connected to each other along the longitudinal direction 152. A specific example of this configuration will be explained later, with reference to FIG. 8A and FIG. 8B. Over the entire dimension L2a of the transverse direction 151, each of the second photoelectric conversion bodies 121 may be electrically connected to a second photoelectric conversion body 121 adjacent along the longitudinal direction 152.

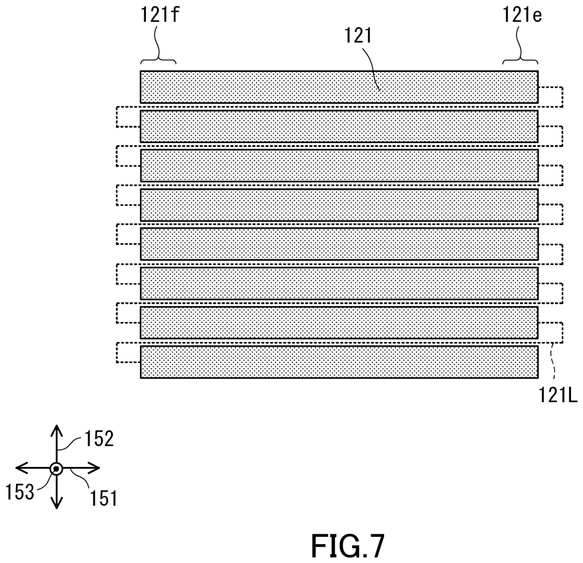

FIG. 7 is an explanatory diagram of a variation of the electrical connection of the second photoelectric conversion bodies 121. In FIG. 7, the electrical connection is shown schematically with a dotted line 121L. The second photoelectric conversion bodies 121 are electrically connected in series. Specifically, each of the second photoelectric conversion bodies 121 includes an end portion 121e and an end portion 121f facing each other in the transverse direction 151. Each of the end portion 121e and the end portion 121f is, for example, a region of the second photoelectric conversion body 121 equally divided into ten divisions in the transverse direction 151. As for the second photoelectric conversion bodies 121, the end portion 121e of one of two adjacent second photoelectric conversion bodies 121 is electrically connected to the end portion 121f of the other second photoelectric conversion body 121.

As shown in FIG. 2A, the second structure 120 includes a second support frame 128. The second support frame 128 supports at least one second photoelectric conversion body 121. When viewed from the orthogonal direction 153, the second support frame 128 has a closed frame shape. In the present embodiment, an inner contour and an outer contour of the closed frame shape are rectangles. When viewed from the orthogonal direction 153, at least part of the second photoelectric conversion body 121 is located within the closed frame. In the present embodiment, the entire second photoelectric conversion body 121 is located within this closed frame. The second support frame 128 is made of metal or resin, for example. In the present embodiment, the second support frame 128 supports at least one second photoelectric conversion body 121 via the third substrate 123.

As shown in FIG. 2A, the second support frame 128 includes a fifth frame member 128A, a sixth frame member 128B, a seventh frame member 128C, and an eighth frame member 128D. The fifth frame member 128A and the sixth frame member 128B extend in the transverse direction 151. The fifth frame member 128A and the sixth frame member 128B face each other. The seventh frame member 128C connects the fifth frame member 128A and the sixth frame member 128B. The eighth frame member 128D connects the fifth frame member 128A and the sixth frame member 128B. The seventh frame member 128C and the eighth frame member 128D face each other. When viewed from the orthogonal direction 153, the fifth frame member 128A, the sixth frame member 128B, the seventh frame member 128C, and the eighth frame member 128D are combined to configure the shape of the above-mentioned closed frame. The seventh frame member 128C and the eighth frame member 128D extend in a direction different from the transverse direction 151, specifically these frame members extend in the longitudinal direction 152.

As shown in FIG. 3, the second structure 120 includes a third substrate 123, a fourth substrate 124, and a spacer 125. The third substrate 123 is provided on the exterior side. The fourth substrate 124 is provided on the interior side. The third substrate 123 and the fourth substrate 124 are made of glass. The spacer 125 has a closed frame shape when viewed from the orthogonal direction 153. The double glazing 126 is configured with the third substrate 123, the fourth substrate 124, and the spacer 125. A void layer 126a is provided inside the double glazing 126 partitioned by the third substrate 123, the fourth substrate 124, and the spacer 125. The void layer 126a is, for example, an air layer. Alternatively, it may be, for example, an argon layer or for example, a layer with a higher degree of vacuum than the outside air. At least one second photoelectric conversion body 121 is disposed inside the void layer 126a and supported by the third substrate 123. The third substrate 123 protects the at least one second photoelectric conversion body 121. A specific light transmittance of the third substrate 123 in the orthogonal direction 153 is, for example, 30% or more and less than 100%. A specific light transmittance of the fourth substrate 124 in the orthogonal direction 153 is, for example, 30% or more and less than 100%.

The second structure 120 includes at least one light-shielding body 129. In the present embodiment, the at least one light-shielding body 129 includes at least one second photoelectric conversion body 121 and a second support frame 128.

A specific light transmittance of the at least one light-shielding body 129 in the orthogonal direction 153 is less than 100%. A specific light transmittance of the at least one light-shielding body 129 in the orthogonal direction 153 may be 90% or less, may be 70% or less, may be 50% or less, may be 30% or less, or may be 10% or less.

A guide 170 guides a first relative move in which the second structure 120 moves in the transverse direction 151 with respect to the first structure 110. In the first relative move, of the first structure 110 and the second structure 120, either only the first structure 110 or only the second structure 120 may move. In the first relative move, both the first structure 110 and the second structure 120 may move.

Specifically in the present embodiment, the guide 170 includes the first frame member 109A and the second frame member 109B of the window frame 109. The first frame member 109A and the second frame member 109B face each other and extend in the transverse direction 151.

In the present embodiment, the guide 170 allows at least one of the first structure 110 and the second structure 120 to move in the transverse direction 151, while engaging with at least one of the first structure 110 and the second structure 120. Specifically, the guide 170 allows at least one of the first structure 110 and the second structure 120 to slide in the transverse direction 151 while the guide 170 mutually fitting with at least one of the first structure 110 and the second structure 120.

Specifically, as shown in FIG. 3, the guide 170 has a first groove 171 and a second groove 172. The first groove 171 and the second groove 172 extend in the transverse direction 151 so as to clamp the first structure 110 from the longitudinal direction 152. The first groove 171 and the second groove 172 may allow the first structure 110 to move in the transverse direction 151. More specifically, the first groove 171 and the second groove 172 may allow the first support frame 118 to move in the transverse direction 151.

The guide 170 further has a third groove 175 and a fourth groove 176. The third groove 175 and the fourth groove 176 extend in the transverse direction 151 so as to clamp the second structure 120 from the longitudinal direction 152. The third groove 175 and the fourth groove 176 may allow the second structure 120 to move in the transverse direction 151. More specifically, the third groove 175 and the fourth groove 176 may allow the second support frame 128 to move in the transverse direction 151.

In the present embodiment, the first relative move achieves a state in which at least one of the first photoelectric conversion bodies 111 overlaps with the seventh frame member 128C when viewed from the orthogonal direction 153. Specifically, the first relative move achieves a state in which the seventh frame member 128C and the first photoelectric conversion bodies 111 overlap with each other when viewed from the orthogonal direction 153. In the present embodiment, the first relative move achieves a state in which at least one of the first photoelectric conversion bodies 111 overlaps with the eighth frame member 128D when viewed from the orthogonal direction 153. Specifically, the first relative move achieves a state in which the eighth frame member 128D and the first photoelectric conversion bodies 111 overlap with each other when viewed from the orthogonal direction 153. When viewed from the orthogonal direction 153, the fifth frame member 128A and the first photoelectric conversion bodies 111 do not overlap with each other. The first relative move achieves a state in which the fifth frame member 128A and the first frame member 118A overlap with each other when viewed from the orthogonal direction 153. When viewed from the orthogonal direction 153, the sixth frame member 128B and the first photoelectric conversion bodies 111 do not overlap with each other. The first relative move achieves a state in which the sixth frame member 128B and the second frame member 118B overlap with each other when viewed from the orthogonal direction 153.

The first photoelectric conversion body 111 converts light into electric charge. Specifically, the first photoelectric conversion body 111 includes a material capable of converting light into electric charge. The first photoelectric conversion body 111 may include a perovskite compound. The first photoelectric conversion body 111 may include silicon. In the present embodiment, the first photoelectric conversion body 111 is in the form of a film, specifically a thin-film type photoelectric conversion body. A thin-film type photoelectric conversion body refers to a photoelectric conversion body with a thickness of 100 nm or more and 10 µm or less. Specifically, the lower limit of the thickness range of the thin-film type photoelectric conversion body may be 500 nm. The upper limit of the thickness range of the thin-film type photoelectric conversion body may be 1.5 µm.

A second photoelectric conversion body 121 converts light into electric charge. Specifically, the second photoelectric conversion body 121 includes a material capable of converting light into electric charge. The second photoelectric conversion body 121 may include a perovskite compound. The second photoelectric conversion body 121 may include silicon. In the present embodiment, the second photoelectric conversion body 121 is in the form of a film, specifically a thin-film type photoelectric conversion body.

The first photoelectric conversion body 111 may be configured using a part or all of one or a plurality of integrated solar cell modules. FIG. 8A is a plan view of a first configuration example in which an integrated solar cell module 50 is used. FIG. 8B is a cross-sectional view of the first configuration example in which the integrated solar cell module 50 is used. Specifically, FIG. 8B is a cross-sectional view of the integrated solar cell module 50 shown in FIG. 8A, taken along a line VIIIB-VIIIB and viewed in a direction indicated with a pair of arrows. In FIG. 8A, elements other than the light-absorbing layer 23 in the unit cell 20 are not shown. In FIG. 8B, some of the components of the integrated solar cell module 50 are not shown.

As shown in FIG. 8A, in the integrated solar cell module 50, the light-absorbing layers 23 each extend in the transverse direction 151 as the length direction of the light-absorbing layer 23.

The integrated solar cell module 50 includes a light-transmissive substrate 6 and a plurality of unit cells 20. Among the unit cells 20, unit cells 20 adjacent to each other are electrically connected in series.

As shown in FIG. 8B, the integrated solar cell module 50 includes a light-transmissive substrate 6, a first electrode 16, an electron transport layer 15, a porous layer 14, a light-absorbing layer 13, a hole transport layer 12, and a second electrode 11, these components being stacked in this order. The light-absorbing layer 13 includes a perovskite compound represented by a formula AMX₃, for example. Here, A is a monovalent cation, M is a divalent cation, and X is a monovalent anion.

The first electrode 16, the electron transport layer 15, and the porous layer 14 are divided by first dividing grooves 17 into a plurality of first electrodes 26, a plurality of electron transport layers 25, and a plurality of porous layers 24, respectively. The light-absorbing layer 13 and the hole transport layer 12 are divided by second dividing grooves 18 into a plurality of light-absorbing layers 23 and a plurality of hole transport layers 22, respectively. The second electrode 11 is divided by third dividing grooves 19 into a plurality of second electrodes 21. In the first configuration example, the third dividing grooves 19 are formed also in the light-absorbing layer 13 and the hole transport layer 12. The first dividing grooves 17, the second dividing grooves 18, and the third dividing grooves 19 extend like stripes in the transverse direction 151.

In the first configuration example, part of the light-absorbing layer 23 extends into the first dividing groove 17. Part of the second electrode 21 extends into the second dividing groove 18. A space is formed in the interior of the third dividing groove 19.

Each of the unit cells 20 has a layered structure in which the first electrode 26, the electron transport layer 25, the porous layer 24, the light-absorbing layer 23, the hole transport layer 22, and the second electrode 21 are stacked in this order. Each second dividing groove 18 is disposed so as to overlap with the first electrode 26, the electron transport layer 25, and the porous layer 24 when viewed from the direction 153. In a second dividing groove 18, the second electrode 21 of an adjacent unit cell 20 is disposed. The first electrode 26 is electrically connected to the second electrode 21 of the adjacent unit cell 20 in the second dividing groove 18. In other words, the second dividing grooves 18 function as cell-connecting grooves.

Each of the unit cells 20 is an independent solar cell including an electron transport layer 25, a porous layer 24, a light-absorbing layer 23, and a hole transport layer 22, which form an n-i-p junction, and further including the first electrode 26 and the second electrode 21 both of which are output terminals.

The following is an explanation of an electrical connection of the unit cells 20 with reference to a certain unit cell 20 (first unit cell 20A) together with a second unit cell 20B and a third unit cell 20C both being adjacent to the first unit cell 20A.

The first electrode 26 of the first unit cell 20A is electrically connected to the second electrode 21 of the third unit cell 20C, where the second unit cell 20B and the third unit cell 20C are located each to be adjacent to the unit cell 20A. The second electrode 21 of the first unit cell 20A is electrically connected to the first electrode 26 of the second unit cell 20B. In this way, the unit cells 20 are electrically connected in series. The light-absorbing layers 23 are electrically connected in series. In FIG. 8B, the electrical connection is schematically depicted with a broken line 50L. Specifically, as indicated with the broken line 50L, a unit current path is repeatedly formed where a current flows from a light-absorbing layer 23 to another light-absorbing layer 23 via the hole transport layer 22, the second electrode 21, the porous layer 24, the electron transport layer 25, the first electrode 26, the electron transport layer 25, and the porous layer 24 in this order. Electric power can be extracted from one or a plurality of the first electrodes 26 and one or a plurality of the second electrodes 21. In FIG. 8B, an example of a power extraction position is schematically indicated with a diamond mark (◆). In an integrated solar cell module 50 having the unit cells 20, the light-absorbing layer 23 formed on the porous layer 24 is in contact with the first electrode 26 and the electron transport layer 25 within the first dividing groove 17, where the first electrode 26 and the electron transport layer 25 are layers provided below the porous layer 24.

The first photoelectric conversion body 111 may be configured according to the first configuration example. Every light-absorbing layer 23 extending in the transverse direction 151 as the length direction can correspond to every first photoelectric conversion body 111 extending continuously. The light-transmissive substrate 6 can correspond to the first substrate 113.

The second photoelectric conversion body 121 may be configured according to the first configuration example. Every light-absorbing layer 23 extending in the transverse direction 151 as the length direction can correspond to every second photoelectric conversion body 121 that extends continuously. The light-transmissive substrate 6 may correspond to the third substrate 123.

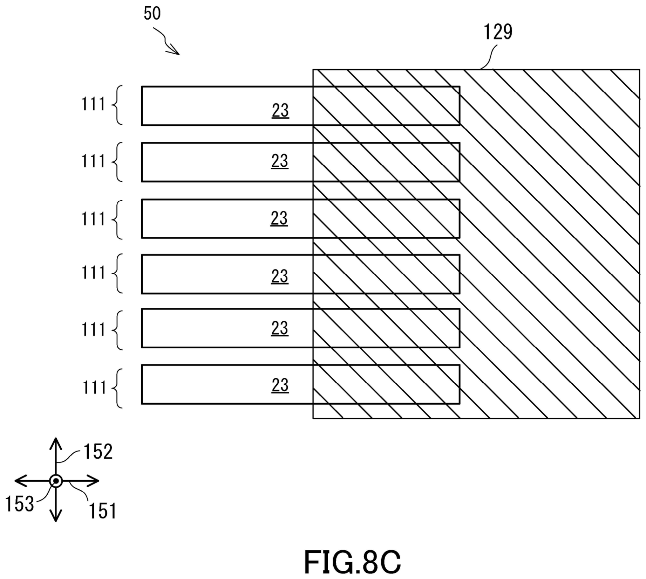

By configuring the first photoelectric conversion body 111 according to the first configuration example as described above, damage to the first photoelectric conversion body 111 can be avoided. This will be explained below. FIG. 8C is an explanatory diagram of damage avoidance function of the first configuration example.

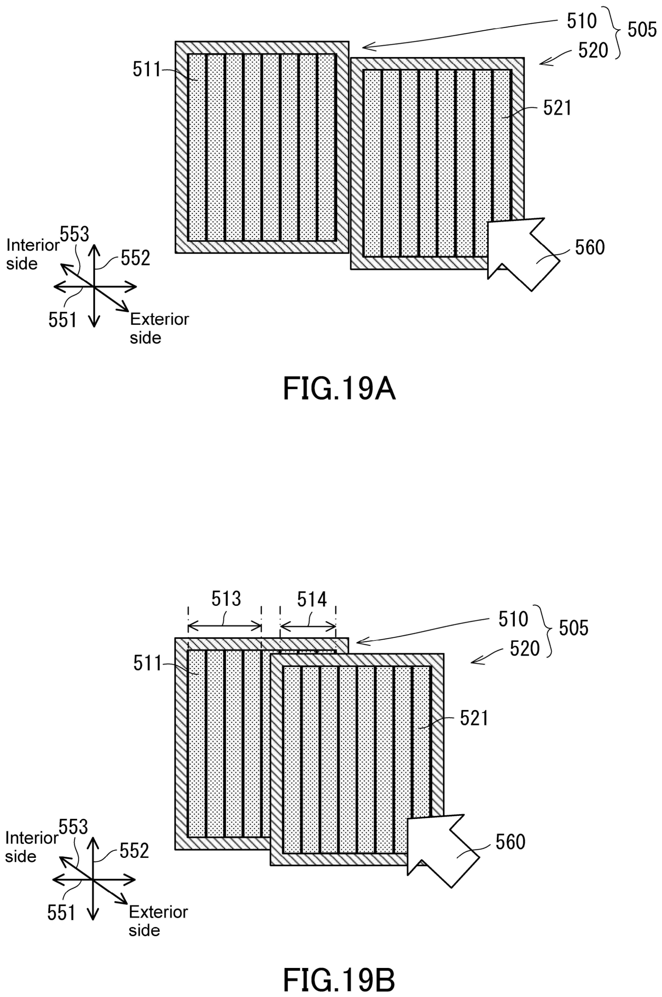

When the light-shielding body 129 moves relatively with respect to the integrated solar cell module 50 in the transverse direction 151, a plurality of light-absorbing layers 23 can be light-shielded by the light-shielding body 129. The shielding is performed such that a light-absorbing layer 23 that is not light-shielded at all and a light-shielding layer 23 that is completely light-shielded do not appear at a time. As a result, a voltage of electric power generated at a light-absorbing layer 23 that is not light-shielded at all will not be applied to a light-absorbing layer 23 that is completely light-shielded. This can avoid damage caused by application of a reverse bias voltage to the light-absorbing layer 23 that is completely light-shielded. In this regard, reference should be made to the following description with reference to FIG. 19A to FIG. 19C and FIG. 1A to FIG. 1C.

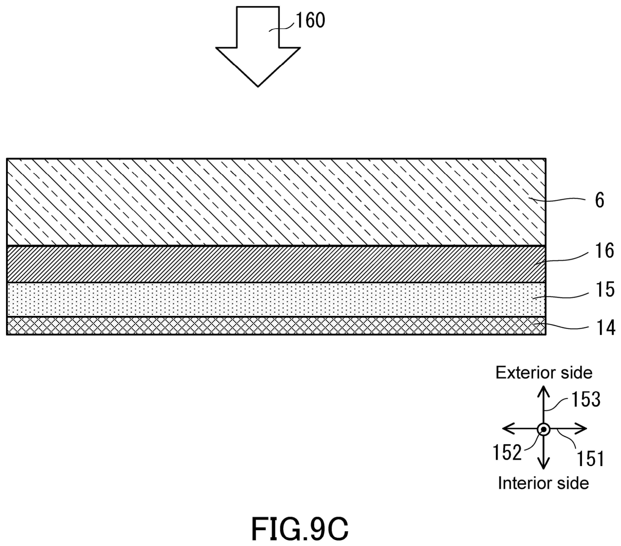

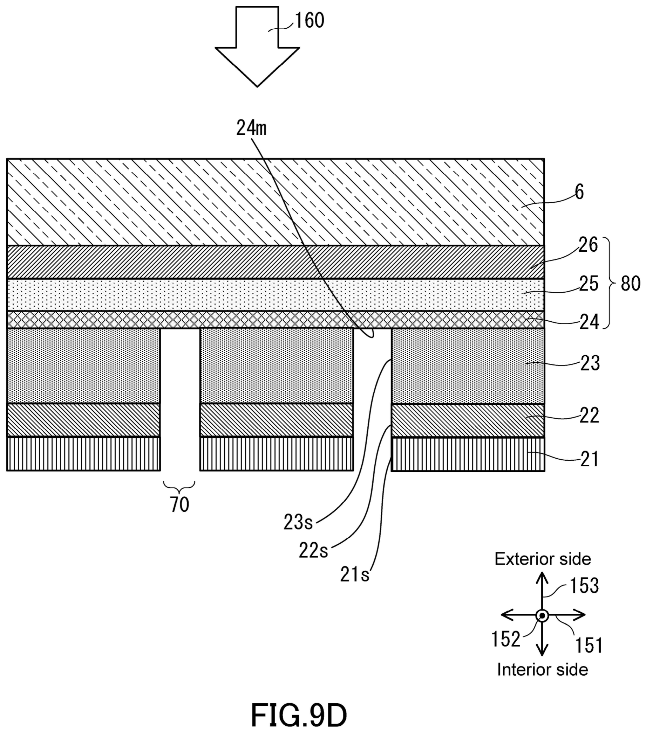

FIG. 9A is a plan view of a second configuration example where an integrated solar cell module 50 is used. FIG. 9B to FIG. 9D are cross-sectional views of the second configuration example where the integrated solar cell module 50 is used. Specifically, FIG. 9B is a cross-sectional view of the integrated solar cell module 50 shown in FIG. 9A, taken along a line IXB-IXB and viewed in the direction indicated with a pair of arrows. FIG. 9C is a cross-sectional view of the integrated solar cell module 50 shown in FIG. 9A, taken along the line IXC-IXC and viewed in the direction indicated with a pair of arrows. In FIG. 9B, the positions corresponding to the IXC-IXC line and the section line 159 in FIG. 9A are shown. The position of the section line 159 in FIG. 9B changes depending on which part of the light-absorbing layer 23 and the second electrode 21 the section line 159 in FIG. 9A passes through. For indication, three section lines 159 are depicted in FIG. 9B. One of the three section lines 159 in FIG. 9B is denoted as a line IXD-IXD. The line IXD-IXD is a section line that passes through the first electrode 26, the electron transport layer 25, the porous layer 24, the light-absorbing layer 23, the hole transport layer 22, and the second electrode 21. FIG. 9D is a cross-sectional view of the integrated solar cell module 50 shown in FIG. 9B, taken along the line IXD-IXD, and viewed in the direction indicated with a pair of arrows. In FIG. 9A, elements other than the light-absorbing layer 23 in the unit cell 20 are not shown. In FIG. 9B to FIG. 9D, part of the elements of the integrated solar cell module 50 is not shown. The second configuration example is described below. Hereinafter, elements common to the first configuration example and second configuration example are given the same reference numbers, and descriptions of those elements are omitted.

As shown in FIG. 9A, the integrated solar cell modules 50 configure an array 60. In the array 60, the integrated solar cell modules 50 each extend in the longitudinal direction 152 as the length direction. The integrated solar cell modules 50 are aligned in the transverse direction 151 of the integrated solar cell modules 50.

As can be understood from FIG. 9A, FIG. 9C and FIG. 9D, grooves 70 are formed between light-absorbing layers 23 adjacent to each other in the transverse direction 151, between hole transport layers 22 adjacent to each other in the transverse direction 151, and between second electrodes 21 adjacent to each other in the transverse direction 151. Unit cells 20 are not configured on the grooves 70.

As shown in FIG. 9D, the grooves 70 each face a side face 21s of the second electrode 21, a side face 22s of the hole transport layer 22, a side face 23s of the light-absorbing layer 23, and a main face 24m of the porous layer 24. Here, a main face of an element is a face orthogonal to the thickness direction of the element. A side face of an element is a face connecting two opposite main faces of the element. In the second configuration example, the thickness direction of the second electrode 21, the thickness direction of the hole transport layer 22, the thickness direction of the light-absorbing layer 23, the thickness direction of the porous layer 24, the thickness direction of the electron transport layer 25, and the thickness direction of the first electrode 26 coincide with the orthogonal direction 153.

As shown in FIG. 9B, in each integrated solar cell module 50, the first dividing grooves 17, the second dividing grooves 18, and the third dividing grooves 19 extend like stripes in the transverse direction 151.

In each integrated solar cell module 50, the unit cells 20 are electrically connected in series. The light-absorbing layers 23 are electrically connected in series. The light-absorbing layers 23 are aligned in the longitudinal direction 152.

In FIG. 9B, an example of a power extraction position is schematically indicated with a diamond mark (◆)**,** as in FIG. 8B. The power extracted from each integrated solar cell module 50 can be integrated later.

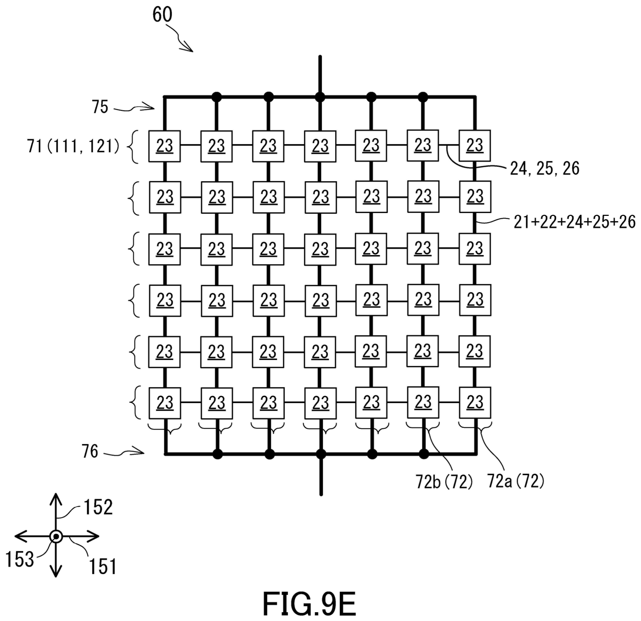

FIG. 9E is an explanatory diagram of an electrical connection of the light-absorbing layers 23 in the second configuration example. The light-absorbing layers 23 are arrayed to configure a plurality of rows 71 and a plurality of columns 72. Here, each row 71 is an alignment in the transverse direction 151. Each column 72 is an alignment in the longitudinal direction 152.

In each of the columns 72, the light-absorbing layers 23 are connected in series. Specifically, in each column 72, two adjacent light-absorbing layers 23 are connected by use of the second electrode 21, the hole transport layer 22, the porous layer 24, the electron transport layer 25, and the first electrode 26.

The rows 71 each include m light-absorbing layers 23 (m is a positive integer equal to or greater than 2). In each of the rows 71, the light-absorbing layers 23 that are adjacent to each other are divided by the grooves 70. In other words, in each row 71, m light-absorbing layers 23 are divided by (m-1) grooves 70. As can be understood from FIG. 9D and FIG. 9E, in each row 71, a continuous structure 80 facing (m-1) grooves 70 is provided. When viewed from the orthogonal direction 153, each of the light-absorbing layers 23 at least partially overlaps with the continuous structure 80. In each row 71, the light-absorbing layers 23 each are electrically connected to the continuous structure 80, thereby electrically connecting the light-absorbing layers 23. In the second configuration example, the continuous structure 80 is disposed between the light-transmissive substrate 6 and the light-absorbing layers 23. Specifically, the continuous structure 80 includes the first electrode 26, the electron transport layer 25, and the porous layer 24.

In each column 72, a serially-connected body of a plurality of light-absorbing layers 23 are configured. Serially-connected bodies with respect to the columns 72 are electrically connected in parallel by a first extraction circuit 75 and a second extraction circuit 76. At the time of obtaining electric power from these serially-connected bodies via the first extraction circuit 75 and the second extraction circuit 76, a control voltage may be applied between the first extraction circuit 75 and the second extraction circuit 76. In one specific example, electric power is obtained from these serially-connected bodies via the first extraction circuit 75 and the second extraction circuit 76 by means of maximum power point tracking (MPPT).

The first configuration example shown in FIG. 8A and FIG. 8B is advantageous from the viewpoint of increasing the ratio of an area occupied by the light-absorbing layers 23 on the light-transmissive substrate 6 and increasing the generated electric power. In contrast, the second configuration example shown in FIG. 9A to FIG. 9E is advantageous from the viewpoint of increasing light transmissivity.

The first photoelectric conversion body 111 may be configured according to the second configuration example. The integrated solar cell modules 50 each have one light-absorbing layer 23 at a common position with respect to the longitudinal direction 152. Those light-absorbing layers 23 may correspond to one first photoelectric conversion body 111 that extends intermittently. In FIG. 9A, for the sake of explanation, the region that can correspond to one first photoelectric conversion body 111 is hatched. In other words, the row 71 shown in FIG. 9E can correspond to one first photoelectric conversion body 111 that extends intermittently. In FIG. 9A and FIG. 9E, a plurality of first photoelectric conversion bodies 111 are provided. This holds true for the third configuration example, the fourth configuration example, and the fifth configuration example, each described below.

The second photoelectric conversion body 121 may be configured according to the second configuration example. Each of the integrated solar cell modules 50 has one light-absorbing layer 23 at a common position with respect to the longitudinal direction 152. The light-absorbing layers 23 can correspond to one second photovoltaic conversion body 121 that extends intermittently. In FIG. 9A, for the sake of explanation, a region that can correspond to a single second photovoltaic converter 121 is hatched. It can also be said that a row 71 shown in FIG. 9E corresponds to one second photoelectric conversion body 121 that extends intermittently. In FIG. 9A and FIG. 9E, a plurality of second photoelectric conversion bodies 121 are provided. This holds true for the third configuration example, the fourth configuration example, and the fifth configuration example described below.

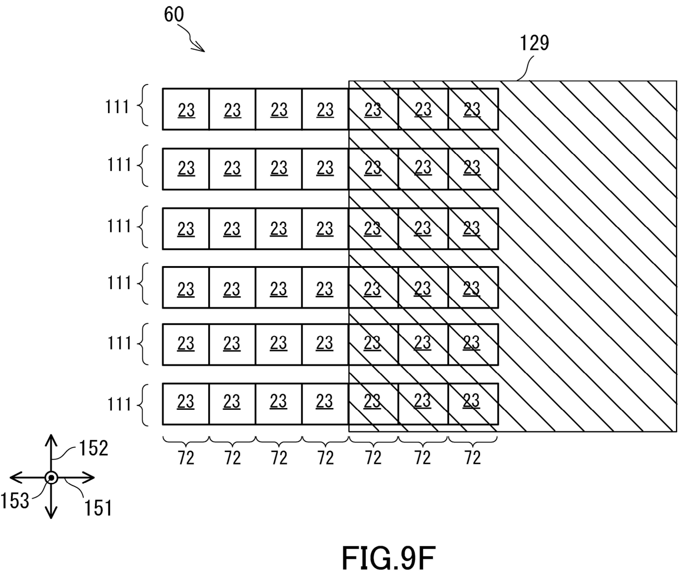

By configuring the first photoelectric conversion body 111 according to the second configuration example as described above, damage to the first photoelectric conversion body 111 can be avoided. This will be specified below. FIG. 9F is an explanatory diagram of a damage avoidance function of the second configuration example. In FIG. 9F, a plurality of columns 72 are configured.

In FIG. 9F, each column 72 has n (n is a positive integer equal to or greater than 2) light-absorbing layers 23. When the light-shielding body 129 relatively moves with respect to the array 60 in the transverse direction 151, a plurality of columns 72 are sequentially light-shielded by the light-shielding body 129. Each of the columns 72 is light-shielded such that all n light-absorbing layers 23 are light-shielded, not such that fewer than n light-absorbing layers 23 are light-shielded. Therefore, in each column 72, the voltage generated due to the power generation in the light-absorbing layer 23 that is not light-shielded at all will not be applied to the light-absorbing layer 23 that is completely light-shielded. As a result, a problem that damage occurring due to the application of a reverse bias voltage to the completely-shielded light-absorbing layer 23 can be avoided. These hold true for the third configuration example, the fourth configuration example and the fifth configuration example as described later.

In FIG. 9E, one of the columns 72 is denoted as a column 72a, and another column 72 is denoted as a column 72b. The column 72a and the column 72b are adjacent to each other in the transverse direction 151. The following description refers to a situation in which all n light-absorbing layers 23 belonging to the column 72a are light-shielded from light, while all n light-absorbing layers 23 belonging to the column 72b are irradiated with light, and electric power is obtained from the array of the light-absorbing layers 23 via the first extraction circuit 75 and the second extraction circuit 76. The current-voltage characteristics of the light-absorbing layer 23 include a region where the voltage changes when the current is approximately zero. In the above situation, the light-absorbing layer 23 belonging to the column 72a can operate at an operating point where the current is approximately zero and the voltage is non-zero in the region. On the other hand, the light-absorbing layer 23 belonging to the column 72b can operate at an operating point where the current is non-zero, although its voltage is balanced with the voltage of the light-absorbing layer 23 belonging to the column 72a. In this way, the light-absorbing layer 23 belonging to the column 72b can generate power without being damaged, although its operating point can be affected by the light-absorbing layer 23 belonging to the column 72a. Typically, the effect is limited. This holds true for the third configuration example, the fourth configuration example and the fifth configuration example as described below.

The following explanation relates to the third configuration example, the fourth configuration example and the fifth configuration example, each using the integrated solar cell module 50. In the descriptions of the third configuration example, the fourth configuration example and the fifth configuration example, part of the descriptions overlapping with the second configuration example may be omitted.

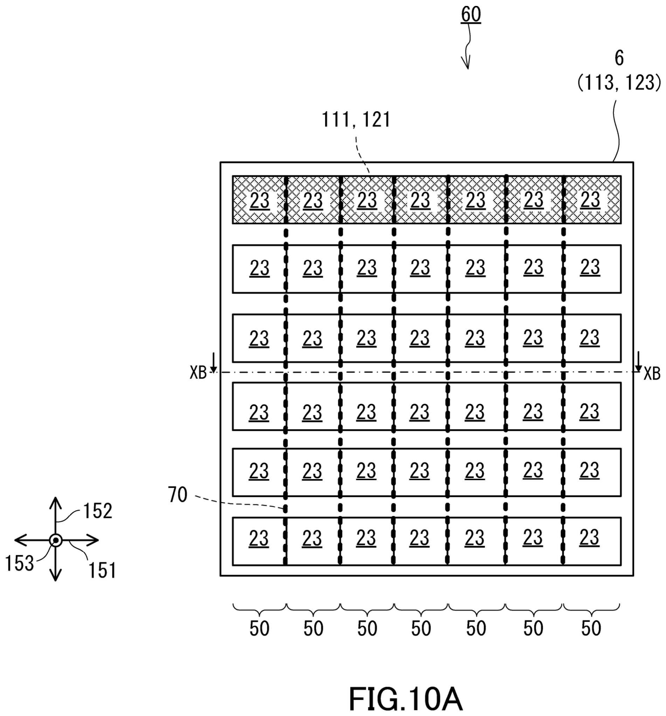

FIG. 10A is a plan view of the third configuration example, where the integrated solar cell module 50 is used. The third configuration example has the same cross-sectional structure as the second configuration example, as shown in FIG. 9B.

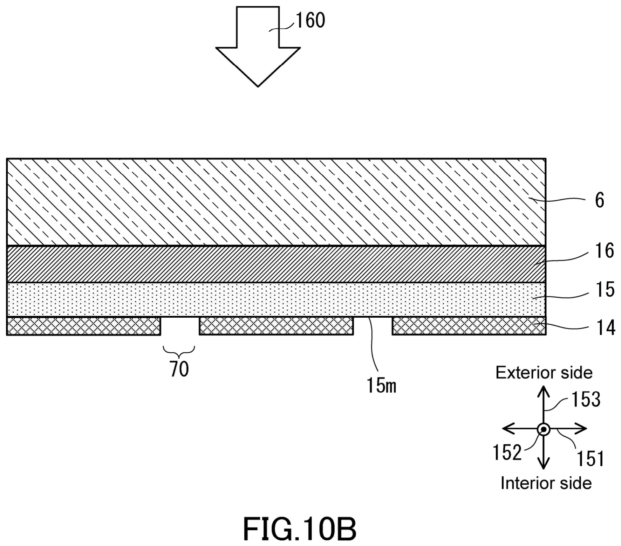

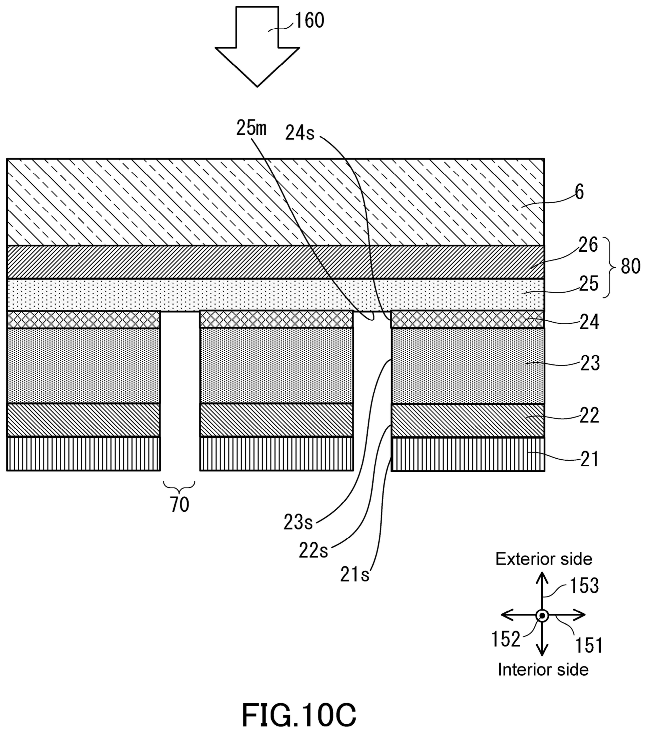

In the third configuration example, the grooves 70 each are shaped deeper than the groove in the second configuration example. In the second configuration example, the grooves 70 are formed in each row 71, whereas in the third configuration example, the grooves 70 are formed in a manner to span the rows 71. FIG. 10B is a cross-sectional view of the integrated solar cell module 50 shown in FIG. 10A, taken along a line XB-XB and viewed in the direction indicated with a pair of arrows. FIG. 10C is a cross-sectional view showing the cross-sectional configuration of the third configuration example, which is a cross-sectional view corresponding to FIG. 9D.

As shown in FIG. 10B, the grooves 70 each penetrate the porous layer 14 and face the main face 15m of the electron transport layer 15. As shown in FIG. 10C, the grooves 70 each face a side face 21s of the second electrode 21, a side face 22s of the hole transport layer 22, a side face 23s of the light-absorbing layer 23, a side face 24s of the porous layer 24, and a main face 25m of the electron transport layer 25.

In the third configuration example, a continuous structure 80 is provided for each row 71, the continuous structure 80 faces the (m-1) grooves 70, as in the second configuration example. When viewed from the orthogonal direction 153, each of the light-absorbing layers 23 at least partially overlaps with the continuous structure 80. In each row 71, each of the light-absorbing layers 23 is electrically connected to the continuous structure 80, whereby the light-absorbing layers 23 are electrically connected to each other. In the third configuration example, the continuous structure 80 is disposed between the light-transmissive substrate 6 and the light-absorbing layers 23, as in the second configuration example. Specifically, the continuous structure 80 includes the first electrode 26 and the electron transport layer 25.

The fourth configuration example has the same structure as the third configuration example, as shown in FIG. 10A and FIG. 9B. However, the grooves 70 in the fourth configuration example each are shaped deeper than the groove in the third configuration example.

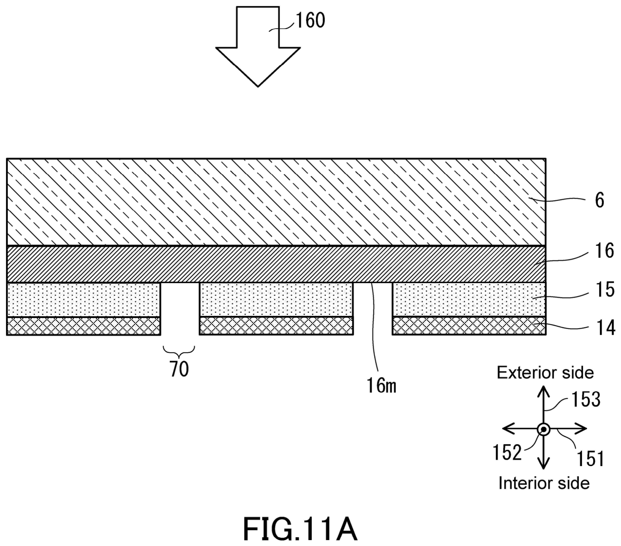

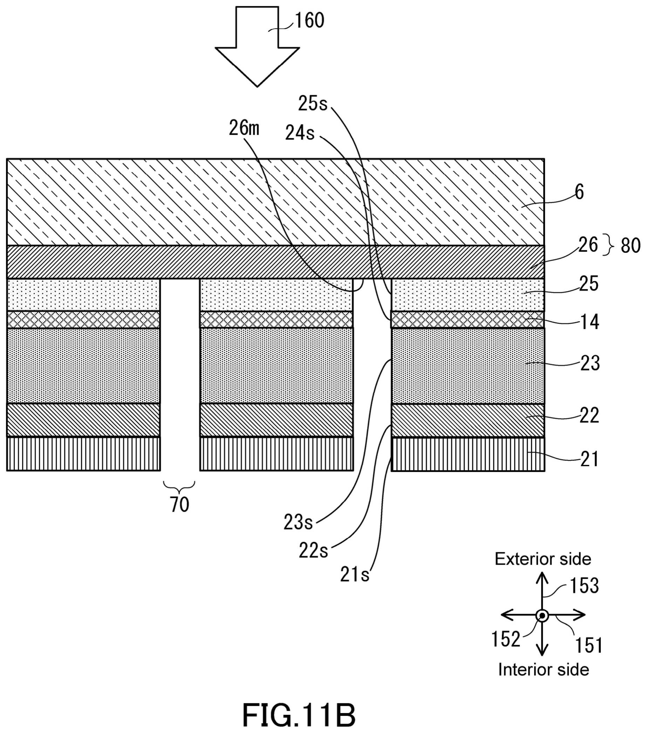

FIG. 11A is a cross-sectional view showing the cross-sectional configuration of the fourth configuration example, the cross section corresponding to FIG. 9C and FIG. 10B. FIG. 11B is a cross-sectional view showing the cross-sectional configuration of the fourth configuration example, the cross-section corresponding to FIG. 9D and FIG. 10C.

As shown in FIG. 11A, the grooves 70 each penetrate the porous layer 14 and the electron transport layer 15, and face the main face 16m of the first electrode 16. As shown in FIG. 11B, the grooves 70 each face a side face 21s of the second electrode 21, a side face 22s of the hole transport layer 22, a side face 23s of the light-absorbing layer 23, a side face 24s of the porous layer 24, a side face 25s of the electron transport layer 25, and a main face 26m of the first electrode 26.

In the fourth configuration example, a continuous structure 80 facing the (m-1) grooves 70 is provided in each row 71, as in the second configuration example and the third configuration example. When viewed from the orthogonal direction 153, each of the light-absorbing layers 23 overlaps at least partially with the continuous structure 80. In each row 71, each of the light-absorbing layers 23 is electrically connected to the continuous structure 80, whereby the light-absorbing layers 23 are electrically connected to each other. In the fourth configuration example, similarly to the second configuration example and the third configuration example, the continuous structure 80 is disposed between the light-transmissive substrate 6 and the light-absorbing layers 23. Specifically, the continuous structure 80 includes the first electrode 26.

The fifth configuration example has the same configuration as the third configuration example and the fourth configuration example, as shown in FIG. 10A and FIG. 9B. However, the grooves 70 in the fifth configuration example each are shaped deeper than the groove in the fourth configuration example.

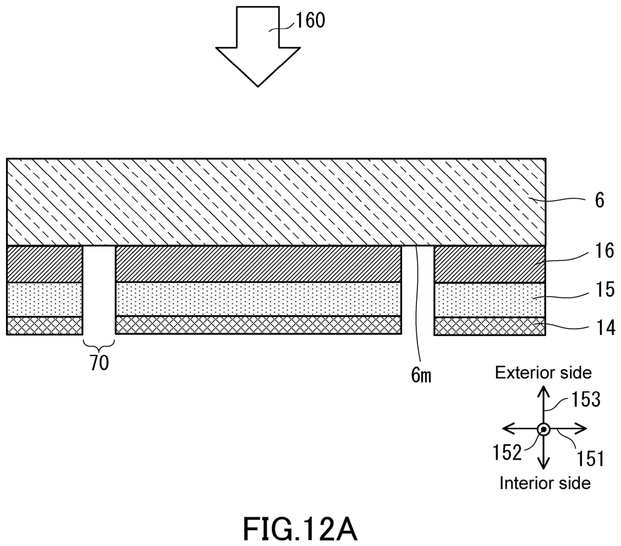

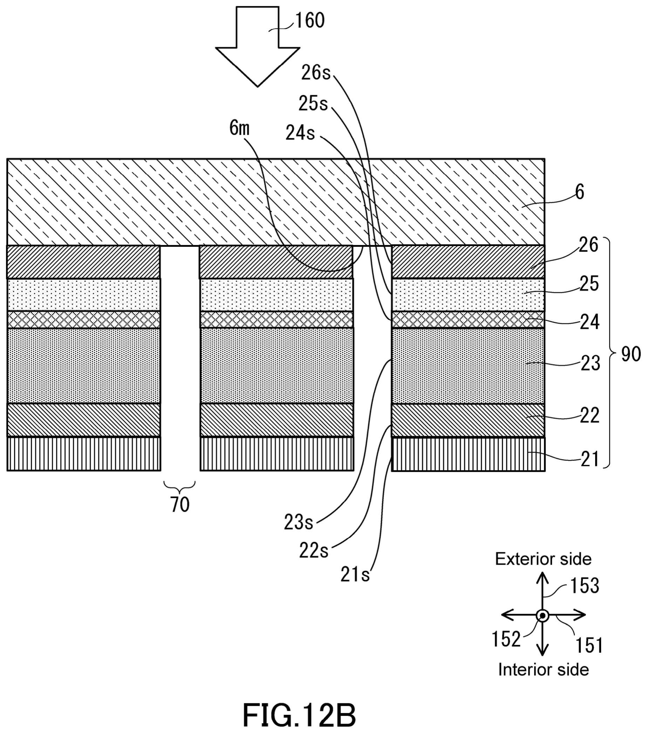

FIG. 12A is a cross-sectional view showing the cross-sectional configuration of the fifth configuration example, the cross section corresponding to FIG. 9C, FIG. 10B, and FIG. 11A. FIG. 12B is a cross-sectional view showing the cross-sectional configuration of the fifth configuration example, the cross-section corresponding to FIG. 9D, FIG. 10C and FIG. 11B.

As shown in FIG. 12A, the grooves 70 each penetrate the porous layer 14, the electron transport layer 15 and the first electrode 16, and face the main face 6m of the light-transmissive substrate 6. As shown in FIG. 12B, the grooves 70 each face a side face 21s of the second electrode 21, a side face 22s of the hole transport layer 22, a side face 23s of the light-absorbing layer 23, a side face 24s of the porous layer 24, a side face 25s of the electron transport layer 25, a side face 26s of the first electrode 26 and a main face 6m of the light-transmissive substrate 6.

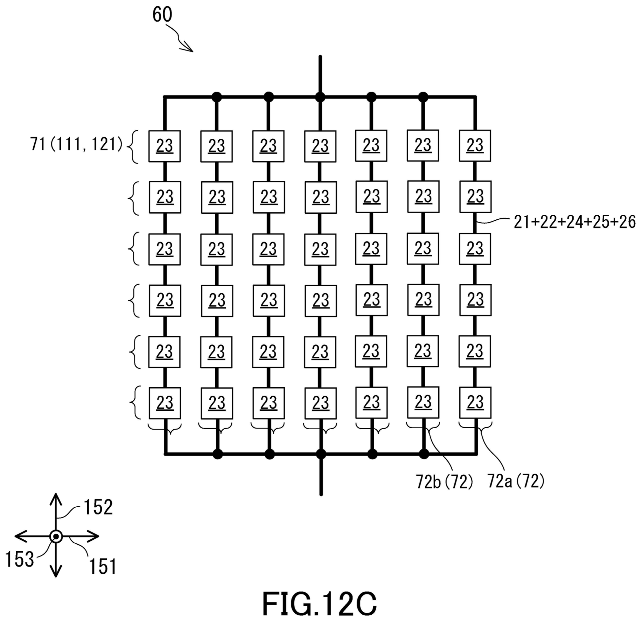

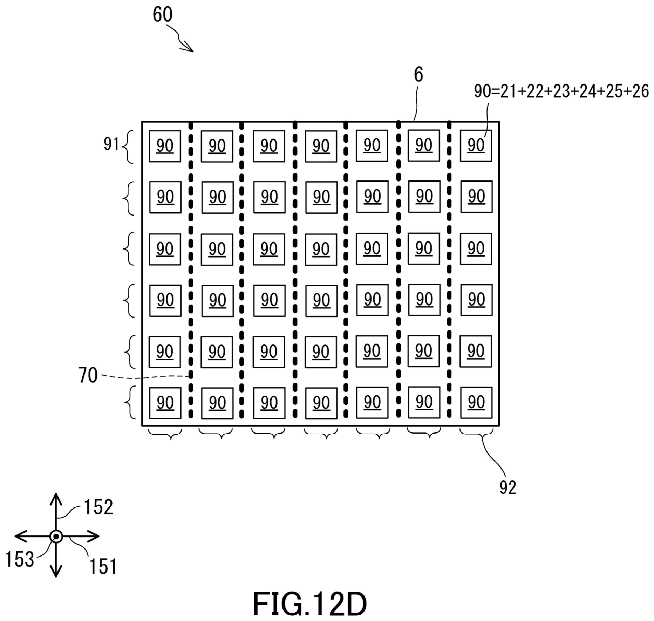

FIG. 12C is an explanatory diagram of the electrical connection of the light-absorbing layer 23 in the fifth configuration example. FIG. 12D is an explanatory diagram of an alignment of a designated structure 90 in the fifth configuration example. In the designated structure 90, the light-absorbing layer 23 is disposed between the first electrode 26 and the second electrode 21 with respect to the orthogonal direction 153. Specifically, the designated structure 90 is a layered structure in which the first electrode 26, the electron transport layer 25, the porous layer 24, the light-absorbing layer 23, the hole transport layer 22, and the second electrode 21 are stacked in this order.

As shown in FIG. 12D, in the fifth configuration example, the designated structures 90 are arrayed to configure a plurality of rows 91 and a plurality of columns 92. Here, each row 91 is an alignment in the transverse direction 151. Each column 92 is an alignment in the longitudinal direction 152.

Each row 91 includes m designated structures 90. As can be understood from FIG. 12B and FIG. 12D, in each row 91, the designated structures 90 that are adjacent to each other are divided by grooves 70. In other words, in each row 91, m designated structures 90 are divided by (m-1) grooves 70.

This will be specified as follows:
- in each row 91, the first electrodes 26 adjacent to each other are divided by the groove 70;
- in each row 91, the electron transport layers 25 adjacent to each other are divided by the groove 70;
- in each row 91, the porous layer 24 adjacent to each other are divided by the groove 70;
- in each row 91, the light-absorbing layers 23 adjacent to each other are divided by the groove 70;
- in each row 91, the hole transport layers 22 adjacent to each other are divided by the groove 70; and
- in each row 91, the second electrodes 21 adjacent to each other are divided by the groove 70.

Appropriate modifications can be applied to the configuration of the integrated solar cell module 50. For details of the integrated solar cell module 50, see Patent Literature 2, for example.

As can be understood from the above description, a first structure 110 includes a plurality of first photoelectric conversion bodies 111. The first photoelectric conversion bodies 111 each extend in the transverse direction 151 as the length direction of the first photelectric conversion body 111. A direction in which the first photoelectric conversion bodies 111 are aligned is the longitudinal direction 152. The second structure 120 includes at least one light-shielding body 129. A guide 170 guides a first relative move in which the second structure 120 moves in the transverse direction 151 with respect to the first structure 110. This configuration can improve the reliability of the photovoltaic power generation system. The mechanism will be described below with reference to FIG. 19A to FIG. 19C and FIG. 1A to FIG. 1C. In the following description, each of the first photoelectric conversion bodies 111 in FIG. 1A to FIG. 1C is assumed to be a single continuous body, similarly to the first configuration example shown in FIG. 8A to FIG. 8C. Even in a case where a first photoelectric conversion body 111 extending intermittently is adopted, similarly to the second configuration example to the fifth configuration example shown in FIG. 9A to FIG. 12D, the effect of improving the reliability of the photovoltaic power generation system can be obtained.

In other words, when the photoelectric conversion bodies include a simultaneous presence of a photoelectric conversion body that is completely light-shielded and a photoelectric conversion body that is not light-shielded at all, the photoelectric conversion body that is completely light-shielded may be damaged. FIG. 19A to FIG. 19C are explanatory diagrams showing a photovoltaic power generation system according to a first reference example.

In the examples of FIG. 19A to FIG. 19C, a window unit 505 includes a first window 510 provided on the interior side and a second window 520 provided on the exterior side. The window unit 505 is opened and closed by moving at least one of the first window 510 and the second window 520 in the transverse direction 551. The window unit 505 shown in FIG. 19A to FIG. 19C is configured as a double-sliding window.

In FIG. 19A to FIG. 19C, a transverse direction 551, a longitudinal direction 552, and an orthogonal direction 553 are shown. The transverse direction 551, the longitudinal direction 552, and the orthogonal direction 553 are mutually orthogonal directions. In the example shown in FIG. 19A to 19C, the transverse direction 551 is the direction for opening/closing the window unit 505. The window unit 505 is opened and closed by moving at least one selected from the group consisting of the first window 510 and the second window 520 in the transverse direction 551. The orthogonal direction 553 is the direction from the exterior to the interior or from the interior to the exterior.

The first window 510 includes a plurality of first photoelectric conversion bodies 511. In FIG. 19A, the first window 510 includes eight first photoelectric conversion bodies 511. The first photoelectric conversion bodies 511 each are electrically connected in series. The first photoelectric conversion bodies 511 each extend in the longitudinal direction (vertical direction) 552 as the length direction of the first photoelectric conversion body 511. A direction in which the first photoelectric conversion bodies 511 are aligned is the transverse direction 551.

The second window 520 includes a plurality of second photoelectric conversion bodies 521. In FIG. 19A, the second window 520 includes eight second photoconductive elements 521. The second photoconductive elements 521 each are electrically connected in series. The second photoconductive elements 521 each extend in the longitudinal direction 552 as the length direction of the second photoelectric conversion body 521. A direction in which the second photoconductive elements 521 are aligned is the transverse direction 551.

In FIG. 19A, the window unit 505 is in a completely closed state. In the example of FIG. 19A, in this state, the first window 510 and the second window 520 do not overlap with each other. While sunlight 560 travels toward the interior from the exterior, electric power is generated not only at the second photoelectric conversion bodies 521 in the second window 520 on the exterior side, but also at the first photoelectric conversion bodies 511 in the first window 510 on the interior side.

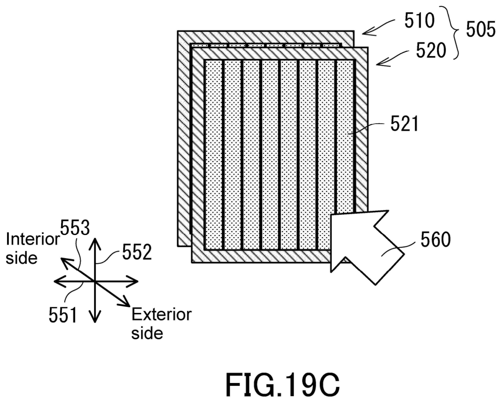

In FIG. 19C, the window unit 505 is in a completely opened state. In the example of FIG. 19C, in this state, the first window 510 and the second window 520 overlap each other. In the presence of the sunlight 560, electric power is generated at the second photoelectric conversion bodies 521 in the second window 520 on the exterior side. On the other hand, electric power is not generated at the first photoelectric conversion bodies 511 in the first window 510 on the interior side, because the first photoelectric conversion bodies 511 are light-shielded from light by the second window 520.

In FIG. 19B, the window unit 505 is ajar. The term "ajar" refers to a state in which the door is partially/half open. In this state, the first window 510 and the second window 520 partially overlap with each other. In the presence of the sunlight 560, electric power is generated at the second photoelectric conversion bodies 521 in the second window 520 on the exterior side. Among the first photoelectric conversion bodies 511 in the first window 510 on the interior side, some photoelectric conversion bodies 513 are not at all light-shielded by the second window 520. Therefore, the photoelectric conversion bodies 513 that are not light-shielded at all generates electric power. On the other hand, among the first photoelectric conversion bodies 511, some photoelectric conversion bodies 514 are completely light-shielded by the second window 520. Therefore, the photoelectric conversion bodies 514 that are completely light-shielded do not generate electric power.

In the situation shown in FIG. 19B, a voltage of electric power generated at the photoelectric conversion body 513 is applied to the photoelectric conversion body 514 that does not generate electric power. In this way, a reverse bias voltage is applied to the photoelectric conversion body 514. When the reverse bias voltage is applied, the photoelectric conversion body 514 may be damaged because the photoelectric conversion body 514 is applied with a large current derived from its voltage-current characteristics.

As can be understood from the above description, if one or some of the photoelectric conversion bodies are not light-shielded at all, and another one or more of the photoelectric conversion bodies are completely light-shielded, the photoelectric conversion bodies that are completely light-shielded may be damaged.

Specifically, in the example shown in FIG. 19A to FIG. 19C, the first photoelectric conversion bodies 511 each extend in the longitudinal direction 552 as the length direction of the first photoelectric conversion body 511. The direction in which the first photoelectric conversion bodies 511 are aligned is the transverse direction 551. The direction of the relative move of the first window 510 and the second window 520 is the transverse direction 551. The direction of the relative move does not coincide with the length direction of the first photoelectric conversion bodies 511, but the direction coincides with a short-side direction. In this arrangement, the first photoelectric conversion bodies 511 may include simultaneously both photoelectric conversion bodies 513 that are not light-shielded at all and generating electric power and photoelectric conversion bodies 514 that are completely light-shielded and generating no electric power (see FIG. 19B). In this case, a reverse bias voltage is applied to the photoelectric conversion bodies 514, and a large current derived from the voltage-current characteristics is applied to cause damage.

In contrast, in the configuration according to the present embodiment, the direction of the first relative move coincides with the length direction of the first photoelectric conversion bodies 111. This configuration serves to prevent first photoelectric conversion bodies 111 from including, at a time, a photoelectric conversion body that is not light-shielded at all and generating electric power and a photoelectric conversion body that is completely light-shielded and generating no electric power. Therefore, it is possible to avoid the above-mentioned damage.

In the example shown in FIG. 1A, the window unit 105 is in a completely closed state. In the example of FIG. 1A, in this state, the first structure 110 and the second structure 120 do not overlap at all. While the sunlight 160 travels toward the interior from the exterior, electric power is generated not only at at least one second photoelectric conversion body 121 in the second structure 120 on the exterior side, but also at the first photoelectric conversion bodies 111 in the first structure 110 on the interior side. In an alternative configuration example, the first structure 110 and the second structure 120 may partially overlap with each other in a state where the window unit 105 is completely closed.

In FIG. 1C, the window unit 105 is in a completely opened state. In the example shown in FIG. 1C, in this state, the first structure 110 and the second structure 120 completely overlap with each other. In the presence of the sunlight 160, electric power is generated at at least one photoelectric conversion body 121 in the second structure 120 on the exterior side. On the other hand, electric power is not generated at the first photoelectric conversion bodies 111 in the first structure 110 on the interior side, because the first photoelectric conversion bodies 111 are light-shielded by the second structure 120.

In FIG. 1B, the window unit 105 is ajar. The term ajar refers to a state in which the door is partially/half open. In this state, the first structure 110 and the second structure 120 partially overlap with each other. In the presence of the sunlight 160, electric power is generated at at least one second photoelectric conversion body 121 in the second structure 120 on the exterior side. Each of the first photoelectric conversion bodies 111 in the first structure 110 on the interior side is partially light-shielded by the second structure 120. However, each of the first photoelectric conversion bodies 111 is not completely light-shielded, and is partially irradiated with the sunlight 160. This can prevent a situation where a reverse bias voltage is applied to the first photoelectric conversion body 111.

According to the explanation made with reference to FIG. 19A to FIG. 19C and FIG. 1A to FIG. 1C, as for the first configuration example shown in FIG. 8A to FIG. 8C, it can be understood that a situation is avoided in which a voltage generated by the light-absorbing layers 23 that are generating power in a state not being light-shielded at all during the relative move, is applied to the light-absorbing layers 23 that are completely light-shielded and generating no electric power, thereby avoiding damage to the light-absorbing layers 23. The second configuration example to the fifth configuration example shown in FIG. 9A to FIG. 9F also can prevent damage to the light-absorbing layers 23, since each of the configuration examples can avoid the situation as explained with reference to FIG. 19A to FIG. 19C and FIG. 1A to FIG. 1C, that is, if light-absorbing layers 23 not light-shielded at all in the relative move generate electric power, the thus generated voltage will be applied to other light-absorbing layers 23 that are completely light-shielded and generating no electric power.

The present embodiment will be further explained by use of the terms "first structure overlapping area", "first reference area", "first overlapping area" and "first overlapping rate". The definitions of these terms are as follows.
- The first structure overlapping area is an area in which the first structure 110 overlaps with the second structure 120 when viewed from the orthogonal direction 153.
- The first reference area is a total area of one of the first photoelectric conversion bodies 111 when viewed from the orthogonal direction 153.
- The first overlapping area is an area in which the aforementioned one first photoelectric conversion body 111 overlaps with at least one light-shielding body 129 when viewed from the orthogonal direction 153.
- The first overlapping rate is a rate of the first overlapping area to the first reference area.

In the present embodiment, the first relative move to increase the first structure overlapping area achieves the following states in this order:
a state in which the first overlapping rate of each of the first photoelectric conversion bodies 111 is more than 0% and less than 50%; and
a state in which the first overlapping rate of each of the first photoelectric conversion bodies 111 is more than 50% and less than 100%. In this configuration, the first photoelectric conversion bodies 111 that have undergone the relative move exclude simultaneous presence of a first photoelectric conversion body 111 having the first overlapping rate of 0% and a first photoelectric conversion body 111 having the first overlapping rate of 100%. As a result, the reliability of the photovoltaic power generation system will be improved.

Specifically, the first relative move that increases the first structure overlapping area achieves the following states, in this order:
a state in which the first overlapping rate of each of the first photoelectric conversion bodies 111 is more than 0% and less than 33%;
a state in which the first overlapping rate of each of the first photoelectric conversion bodies 111 is more than 33% and less than 67%; and
the state in which the first overlapping ratio of each of the first photoelectric conversion bodies 111 is more than 67% and less than 100%.

More specifically, the first relative move that increases the first structure overlapping area achieves the following states in this order:
a state in which the first overlapping ratio of each of the first photoelectric conversion bodies 111 is more than 0% and less than 25%;
a state in which the first overlapping rate of each of the first photoelectric conversion bodies 111 is more than 25% and less than 50%;
a state in which the first overlapping rate of each of the first photoelectric conversion bodies 111 is more than 50% and less than 75%; and
a state in which the first overlapping rate of each of the first photoelectric conversion bodies 111 is more than 75% and less than 100%.

In the present embodiment, the first photoelectric conversion bodies 111 that have undergone the relative move exclude simultaneous presence of a first photoelectric conversion body having the first overlapping rate of 0% and a first photoelectric conversion body having the first overlapping rate of 100%. Specifically, in the present embodiment, a stopper 177 restricts the relative position of the second structure 120 with respect to the first structure 110 to the first range, where the relative position may be achieved by the first relative move. The first photoelectric conversion bodies 111 that have undergone the first relative move within the first range exclude simultaneous presence of a first photoelectric conversion body having the first overlapping rate of 0% and a first photoelectric conversion body having the first overlapping rate of 100%. This configuration can improve the reliability of the photovoltaic power generation system.

As shown in FIG. 2A, the stopper 177 includes a first wall 177A and a second wall 177B. The first wall 177A defines one end of each of the first groove 171, the second groove 172, the third groove 175, and the fourth groove 176 with respect to the transverse direction 151, as shown in FIG. 3. The second wall 177B defines the other end of each of the first groove 171, the second groove 172, the third groove 175 and the fourth groove 176 with respect to the transverse direction 151. Since the first structure 110 and the second structure 120 get contact with the first wall 177A, the first structure 110 and the second structure 120 are prevented from moving in the transverse direction 151. Since the first structure 110 and the second structure 120 get contact with the second wall 177B, the first structure 110 and the second structure 120 are prevented from moving in the transverse direction 151. The term "get contact" means that "touch to be in contact". In the example shown in FIG. 2A, the first wall 177A is the third frame member 109C of the window frame 109. The second wall 177B is the fourth frame member 109D of the window frame 109. The third frame member 109C and the fourth frame member 109D face each other. The third frame member 109C and the fourth frame member 109D extend in a direction different from the transverse direction 151, specifically these frame members extend in the longitudinal direction 152.

In the present embodiment, the first relative move in the first range is performed such that the first overlapping area of each of the first photoelectric conversion bodies 111 is maintained at a uniform state. Here, a standard deviation divided by the arithmetic average is defined as a fluctuation rate. The condition that the first overlapping area of each of the first photoelectric conversion bodies 111 is uniform indicates that the fluctuation rate of the first overlapping area of the first photoelectric conversion bodies 111 is 0% or more and 10% or less. The first relative move in the first range may be maintained such that the fluctuation rate of the first overlapping area of the first photoelectric conversion bodies 111 is 0% or more and 5% or less.

The configuration in which the first overlapping rate changes in the first relative move described above is compatible with the first configuration example to the fifth configuration example shown in FIG. 8A to FIG. 12D. This holds true for a configuration that maintains a state in which the first overlapping area is uniform.

In the present embodiment, the first relative move achieves a state in which the first photoelectric conversion bodies 111 and at least one second photoelectric conversion body 121 overlap with each other at least partially when viewed from the orthogonal direction 153.

In the present embodiment, not only the first structure 110 but also the second structure 120 includes photoelectric conversion body. This configuration is suitable for securing the electric power generated by a photovoltaic power generation system. Specifically, in the present embodiment, when viewed from the orthogonal direction 153, at least part of the at least one second photoelectric conversion body 121 can overlap with at least part of the first photoelectric conversion bodies 111. The layout for allowing the overlap of the photoelectric conversion bodies 111 and 112 allows the photoelectric conversion bodies 111 and 112 to be disposed over a large area. This is suitable for securing the electric power generated by a photovoltaic power generation system.

The following is an explanation for the expression "at least part of at least one second photoelectric conversion body 121 can overlap with at least part of the first photoelectric conversion bodies 111". In the case where at least one second photoelectric conversion body 121 includes a plurality of second photoelectric conversion bodies 121, this expression encompasses, for example, the following structures:
- a structure in which part of only one of the first photoelectric conversion bodies 111 and part of only one of the second photoelectric conversion bodies 121 can overlap with each other; and
- a structure in which all of the first photoelectric conversion bodies 111 and all of the second photoelectric conversion bodies 121 can overlap with each other. In addition, this expression specifically means that the positional relationship of the first structure 110 and the second structure 120 acceptable in the photovoltaic power generation system 100 includes a positional relationship in which at least part of at least one second photoelectric conversion body 121 overlaps with at least part of the first photoelectric conversion bodies 111.

In the present embodiment, the first substrate 113 supports the first photoelectric conversion bodies 111 such that the first photoelectric conversion bodies 111 are disposed in a region that is larger than 50% of the area of the first substrate 113 when viewed from the orthogonal direction 153. This configuration will make it easier to obtain electric power generated by the first photoelectric conversion bodies 111.

Specifically, the first substrate 113 supports the first photoelectric conversion bodies 111 such that the first photoelectric conversion bodies 111 are disposed in a region that accounts for 70% or more of the area of the first substrate 113 when viewed from the orthogonal direction 153. More specifically, the first substrate 113 supports the first photoelectric conversion bodies 111 such that the first photoelectric conversion bodies 111 are disposed in a region that accounts for 90% or more of the area of the first substrate 113 when viewed from the orthogonal direction 153.

In the present embodiment, the third substrate 123 supports at least one second photoelectric conversion body 121 such that at least one second photoelectric conversion body 121 is disposed in a region that is larger than 50% of the area of the third substrate 123 when viewed from the orthogonal direction 153. Specifically, the third substrate 123 supports at least one second photoelectric conversion body 121 such that at least one second photoelectric conversion body 121 is disposed in a region that accounts for 70% or more of the area of the third substrate 123 when viewed from the orthogonal direction 153. More specifically, the third substrate 123 supports at least one second photoelectric conversion body 121 such that at least one second photoelectric conversion body 121 is disposed in a region that accounts for 90% or more of the area of the third substrate 123 when viewed from the orthogonal direction 153.

In the present embodiment, the first substrate 113 is a glass substrate. The first substrate 113 is located between the second structure 120 and the first photoelectric conversion bodies 111 with respect to the orthogonal direction 153. In this way, it is possible to protect the first photoelectric conversion bodies 111 with the first substrate 113 while capturing the sunlight 160 into the first photoelectric conversion bodies 111 through the first substrate 113. The first substrate 113 may be a resin substrate.

In the present embodiment, the third substrate 123 is a glass substrate. The third substrate 123 may be a resin substrate.

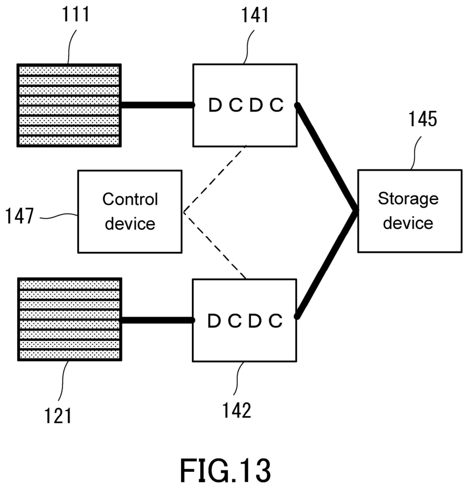

FIG. 13 is an explanatory diagram of the electrical system of a photovoltaic power generation system 100. The photovoltaic power generation system 100 includes a first DC/DC converter 141, a second DC/DC converter 142, a power storage device 145, and a control device 147. The power storage device 145 is, for example, a storage battery or a capacitor, for example.

The first photoelectric conversion bodies 111, the first DC/DC converter 141, and the power storage device 145 are electrically connected in this order. At least one second photoelectric conversion body 121, the second DC/DC converter 142, and the power storage device 145 are electrically connected in this order. The control device 147 controls the first DC/DC converter 141 and the second DC/DC converter 142.

Hereinafter, an expression "first transformation ratio" will be used. A first transformation ratio is a ratio of an output voltage to an input voltage, where the output voltage is supplied from the first DC/DC converter 141 to the power storage device 145 while the input voltage is supplied from the first photoelectric conversion bodies 111 to the first DC/DC converter 141. In one control example, the control device 147 controls the first transformation ratio such that the output voltage from the first DC/DC converter 141 to the power storage device 145 tracks a target value. The first relative move can increase the total of the first overlapping areas for the first photoelectric conversion bodies 111 and decrease the power generation voltage of the first photoelectric conversion bodies 111. In this case, by controlling the first transformation ratio as described above, it is possible to suppress fluctuations in the charging voltage of the power storage device 145. This makes it possible to maintain a high charging efficiency when charging the electric power generated by the first photoelectric conversion bodies 111 to the power storage device 145. The target value may be a fixed value or a variable value.

Other embodiments will be described below. In the following, the same reference symbols are used for elements that are common to the embodiment described above and the embodiment to be described later, and the description of these elements may be omitted. The description for the respective embodiments may be applied mutually unless there is a technical contradiction. The embodiments may be combined with each other unless there is a technical contradiction.

### (Embodiment 2)

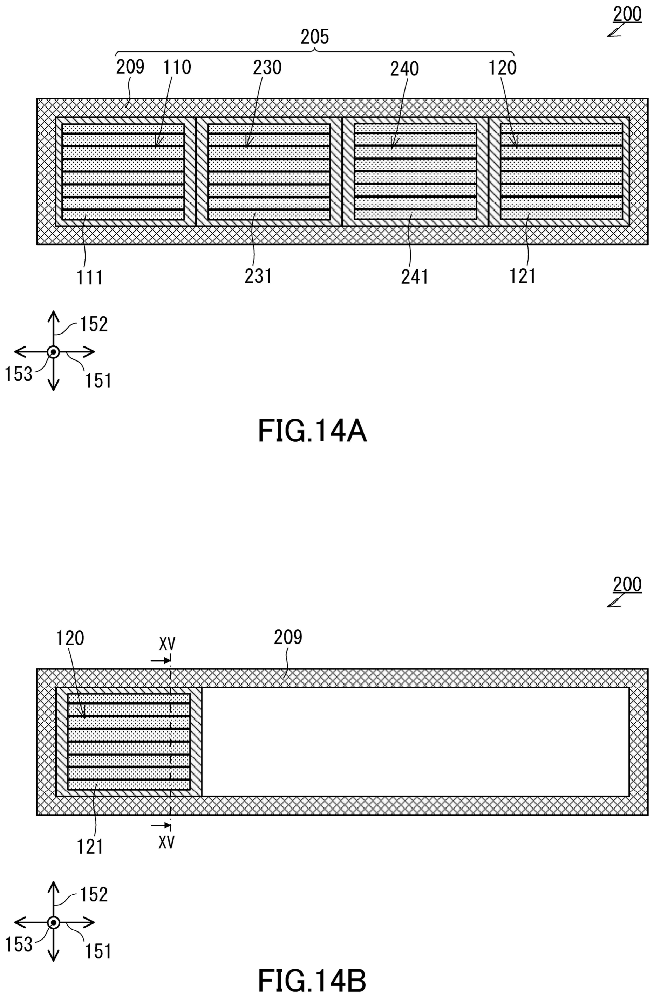

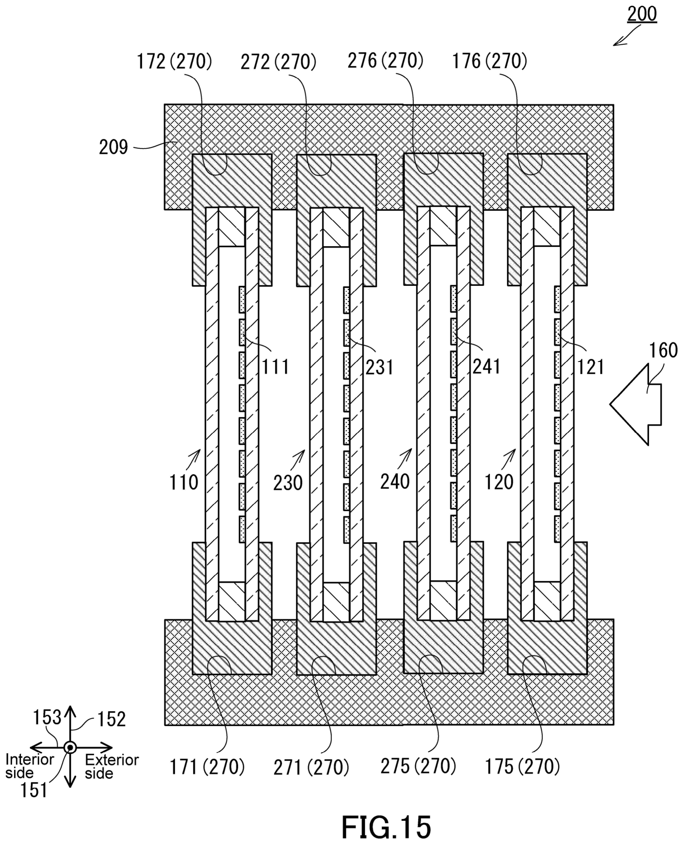

FIG. 14A and FIG. 14B are diagrams showing a photovoltaic power generation system 200 according to Embodiment 2 from the orthogonal direction 153. FIG. 15 is a cross-sectional view of the photovoltaic power generation system 200 according to Embodiment 2. Specifically, in FIG. 14A, the window unit 205 is closed. In FIG. 14B, the window unit 205 is open. FIG. 15 is a cross-sectional view of the photovoltaic power generation system 200 shown in FIG. 14B, taken along a line XV-XV and viewed in the direction indicated with a pair of arrows.

The photovoltaic power generation system 200 includes a third structure 230 and a fourth structure 240. In the present embodiment, the third structure 230 and the fourth structure 240 each are a window. A guide 270 is provided in a window frame 209. The window unit 205 includes the first structure 110, the second structure 120, the third structure 230, the fourth structure 240, and the window frame 209. A sliding window is configured for the window unit 205 of the present embodiment.

The third structure 230 includes a plurality of third photoelectric conversion bodies 231. The third photoelectric conversion bodies 231 are electrically connected in series in the same way as the first photoelectric conversion bodies 111. The third photoelectric conversion bodies 231 each extend in the transverse direction (first direction) 151 as the length direction of the third photoelectric conversion body 231. A direction in which the third photoelectric conversion bodies 231 are aligned is the longitudinal direction (second direction) 152.

The fourth structure 240 includes a plurality of fourth photoelectric conversion bodies 241. The fourth photoelectric conversion bodies 241 are electrically connected in series in the same way as the first photoelectric conversion bodies 111. The fourth photoelectric conversion bodies 241 each extend in the transverse direction (first direction) 151 as the length direction of the fourth photoelectric conversion body 241. A direction in which the fourth photoelectric conversion bodies 241 are aligned is the longitudinal direction (second direction) 152.

The explanation for the expression "the first photoelectric conversion bodies 111 each extend in the transverse direction 151 as the length direction of the first photoelectric conversion body 111" can also be applied to the expression "the third photoelectric conversion bodies 231 each extend in the transverse direction 151 as the length direction of the third photoelectric conversion body 231". The same explanation can also be applied to the expression "the fourth photoelectric conversion bodies 241 each extend in the transverse direction 151 as the length direction of the fourth photoelectric conversion body 241".

The guide 270 guides a second relative move in which the third structure 230 moves with respect to the first structure 110 in the transverse direction 151. In the second relative move, of the first structure 110 and the third structure 230, either only the first structure 110 or only the third structure 230 may move. Alternatively, in the second relative move, both the first structure 110 and the third structure 230 may move.

The guide 270 guides a third relative move in which the second structure 120 moves with respect to the fourth structure 240 in the transverse direction 151. In the third relative move, of the fourth structure 240 and the second structure 120, either only the fourth structure 240 or only the second structure 120 may move. Alternatively, in the third relative move, both the fourth structure 240 and the second structure 120 may move.

In the present embodiment, the guide 270 allows at least one of the first structure 110 and the third structure 230 to move in the transverse direction 151, while engaging with at least one of the first structure 110 and the third structure 230. The guide 270 allows at least one of the fourth structure 240 and the second structure 120 to move in the transverse direction 151, while engaging with at least one of the fourth structure 240 and the second structure 120. Specifically, the guide 270 allows at least one of the first structure 110 and the third structure 230 to slide in the transverse direction 151, while the guide 270 mutually fitting with at least one of the first structure 110 and the third structure 230. The guide 270 allows at least one of the fourth structure 240 and the second structure 120 to slide in the transverse direction 151, while the guide 270 mutually fitting with at least one of the fourth structure 240 and the second structure 120.

Specifically, as shown in FIG. 15, the guide 270 has a fifth groove 271 and a sixth groove 272. The fifth groove 271 and the sixth groove 272 extend in the transverse direction 151 so as to clamp the third structure 230 from the longitudinal direction 152. The fifth groove 271 and the sixth groove 272 allow the third structure 230 to slide in the transverse direction 151.

The guide 270 has a seventh groove 275 and an eighth groove 276. The seventh groove 275 and the eighth groove 276 extend in the transverse direction 151 so as to clamp the fourth structure 240 from the longitudinal direction 152. The seventh groove 275 and the eighth groove 276 allows the fourth structure 240 to slide in the transverse direction 151.

The third structure 230 and the fourth structure 240 are located between the first structure 110 and the second structure 120 with respect to the orthogonal direction 153. The third structure 230 and the fourth structure 240 are located at different positions with respect to the orthogonal direction 153.

Since the explanation related to the first structure 110 described above can be applied to the explanation related to the third structure 230 and the explanation related to the fourth structure 240, the explanation will be omitted. The related explanations include explanations of guides, grooves, DC/DC converters, or the like.

### (Embodiment 3)

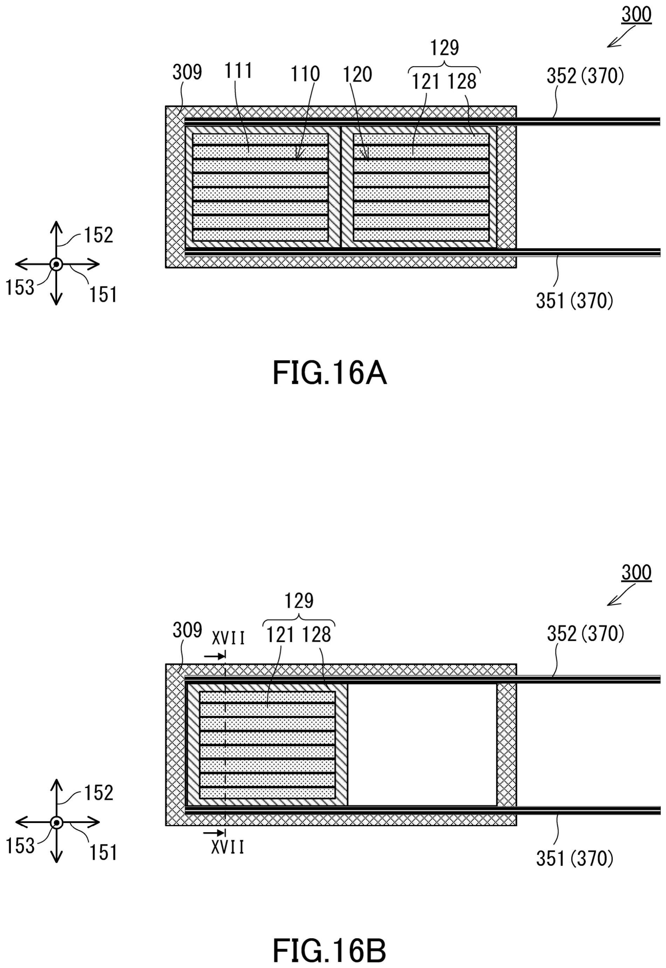

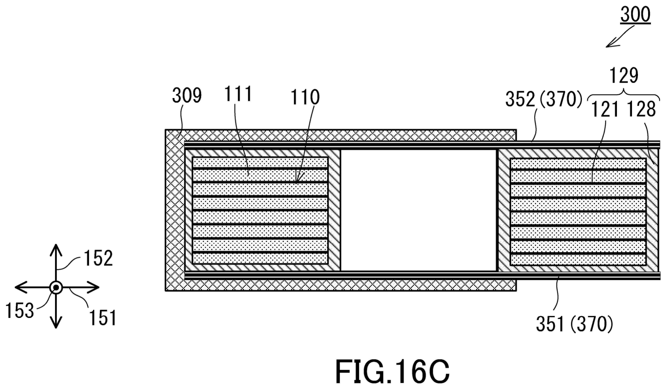

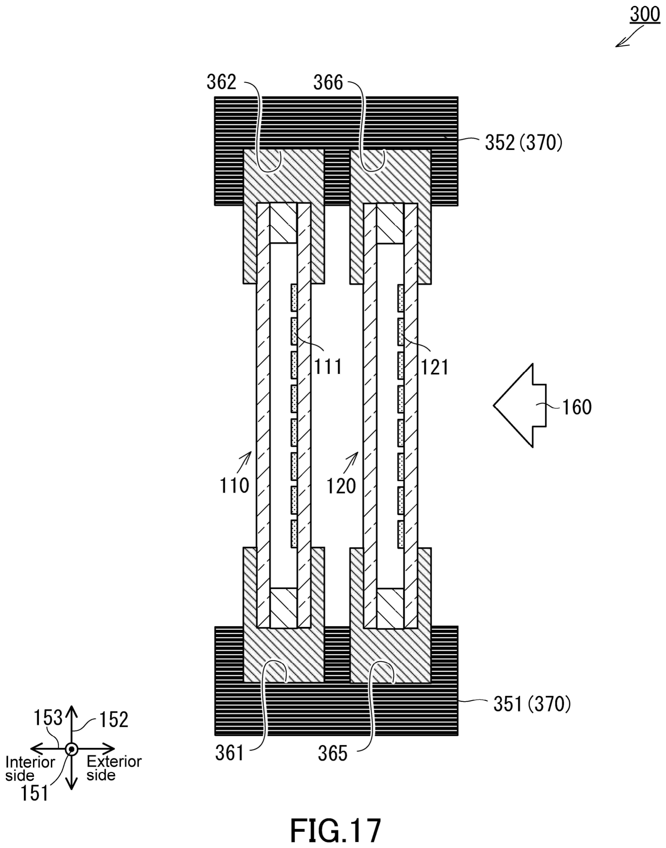

FIG. 16A, FIG. 16B, and FIG. 16C are diagrams showing a photovoltaic power generation system 300 according to Embodiment 3 from the orthogonal direction (third direction) 153. FIG. 17 is a cross-sectional view of the photovoltaic power generation system 300 according to Embodiment 3. Specifically, FIG. 17 is a cross-sectional view of the photovoltaic power generation system 300 shown in FIG. 16B, taken along a line XVII-XVII and viewed in the direction indicated with a pair of arrows. In Embodiment 3, a guide 370 extends over a wider range with respect to the transverse direction 151 than the space enclosed by the window frame 309. In Embodiment 3, the guide 370 is formed of a first rail 351 and a second rail 352, the rails being provided closer to the exterior than the window frame 309. The first rail 351 and the second rail 352 extend in the transverse direction (first direction) 151 to clamp the first structure 110 and the second structure 120 from the longitudinal direction (second direction) 152. A wall is provided around the window frame 309 although it is not illustrated in the drawings. The first rail 351 and the second rail 352 are fixed to the window frame 309 and to the wall.

The first rail 351 and the second rail 352 allow at least one of the first structure 110 and the second structure 120 to move in the transverse direction 151, while engaging with at least one of the first structure 110 and the second structure 120. Specifically, the first rail 351 and the second rail 352 allow at least one of the first structure 110 and the second structure 120 to slide in the transverse direction 151, while the rails mutually fitting with at least one of the first structure 110 and the second structure 120.

Specifically, as shown in FIG. 17, the first rail 351 has a first groove 361. The second rail 352 has a second groove 362. The first groove 361 and the second groove 362 extend in the transverse direction 151 so as to clamp the first structure 110 from the longitudinal direction 152. The first groove 361 and the second groove 362 allow the first structure 110 to slide in the transverse direction 151.

In addition, the first rail 351 has the third groove 365. The second rail 352 has the fourth groove 366. The third groove 365 and the fourth groove 366 extend in the transverse direction 151 so as to clamp the second structure 120 from the longitudinal direction 152. The third groove 365 and the fourth groove 366 allow the second structure 120 to slide in the transverse direction 151.

In FIG. 16A, when viewed from the orthogonal direction 153, the entire space enclosed by the window frame 309 is covered with the first structure 110 and the second structure 120. While the sunlight 160 travels (see FIG. 17) toward the interior from the exterior, electric power is generated not only at at least one second photoelectric conversion body 121 in the second structure 120 on the exterior side, but also at the first photoelectric conversion bodies 111 in the first structure 110 on the interior side.

In FIG. 16B, when viewed from the orthogonal direction 153, the second structure 120 is disposed in a position to overlap with the first structure 110. Part of the space enclosed by the window frame 309 is covered with the first structure 110 and the second structure 120. The remaining part of the space enclosed by the window frame 309 is not covered with either the first structure 110 or the second structure 120. Therefore, the sunlight 160 can be favorably brought into the interior from the exterior through the remaining part of the space. In the presence of the sunlight 160, electric power is generated at at least one second photoelectric conversion body 121 in the second structure 120 on the exterior side. However, electric power is not generated at the first photoelectric conversion bodies 111 in the first structure 110 on the interior side, because the first photoelectric conversion bodies 111 are light-shielded by the light-shielding body 129 in the second structure 120.

In FIG. 16C, when viewed from the orthogonal direction 153, the second structure 120 is disposed in a position offset from the space enclosed by the window frame 309. A part of the space enclosed by the window frame 309 is covered with the first structure 110. A remaining part of the space enclosed by the window frame 309 is not covered with either the first structure 110 or the second structure 120. As a result, the sunlight 160 can be favorably brought into the interior from the exterior through the remaining part of the space. Furthermore, in the presence of the sunlight 160, electric power is generated not only at at least one second photoelectric conversion body 121 in the second structure 120 on the exterior side, but also in the first photoelectric conversion bodies 111 in the first structure 110 on the interior side.

### (Techniques applicable to Embodiment 1, Embodiment 2 and Embodiment 3)

Various techniques can be applied to Embodiment 1, Embodiment 2 and Embodiment 3.

As for variations of the second support frame 128, the seventh frame member 128C and the eighth frame member 128D have a light transmittance higher than a light transmittance of the fifth frame member 128A and the sixth frame member 128B. With this configuration, the seventh frame member 128C and the eighth frame members 128D are unlikely to hinder the incidence of light on the first photoelectric conversion bodies 111. On the other hand, by hiding the wiring or the like behind the fifth frame member 128A and the sixth frame member 128B, an excellent aesthetic appearance can be achieved. The seventh frame member 128C and the eighth frame member 128D are, for example, made of glass or resin. The fifth frame member 128A and the sixth frame member 128B are, for example, made of metal or resin. In this variation, the second support frame 128 may have a portion corresponding to the light-shielding body 129 and a portion not corresponding to the light-shielding body 129.

All of the fifth frame member 128A, the sixth frame member 128B, the seventh frame member 128C, and the eighth frame member 128D may be made of a material having a high light transmittance. In this case, the fifth frame member 128A, the sixth frame member 128B, the seventh frame member 128C, and the eighth frame member 128D are, for example, made of glass or resin. The second support frame 128 may not have a portion corresponding to the light-shielding body 129, and a net for a window screen may be provided at the portion corresponding to the light-shielding body 129. In addition, all of the fifth frame member 128A, the sixth frame member 128B, the seventh frame member 128C, and the eighth frame member 128D may be made of a material having a low light transmittance. In this case, the fifth frame member 128A, the sixth frame member 128B, the seventh frame member 128C, and the eighth frame member 128D are, for example, made of metal or resin.

The above-described technique of using a frame member having a high light transmittance and a frame member having a low light transmittance can also be applied to the first support frame 118. This holds true for the above-described technique in which the four frame members are made of a material having a high light transmittance, and the above technique in which the four frame members are made of a material having a low light transmittance.

FIG. 18 is an explanatory diagram showing a variation in the shape of the support frame. In this variation, an inner contour and an outer contour of the first support frame 118 are parallelograms. An inner contour and an outer contour of the second support frame 128 are parallelograms.

The second structure 120 may or may not have a light-transmitting member. For example, the second structure 120 may be a window screen, a storm shutter, a metal plate, or a colored board. One of the first structure 110 and the second structure 120 may be fixed.

In the first structure 110, the second structure 120, the third structure 230 and the fourth structure 240, the number of glass plates of each structure may not be limited to two. This number may be three or more.

In the embodiment, a window unit including the first structure 110, the second structure 120, and a window frame is configured.

The above explanation relates to Embodiment 1 to Embodiment 3. In each embodiment, the window unit is explained as an example of a horizontally-sliding window, but it may also be formed as a vertically-sliding window (a sash window). For example, the window unit may also be configured as a single-sliding window. In the case of a single-sliding window, one of the first structure 110 and the second structure 120 is fixed, while the other is movable. Even in the case of a single-sliding window, it is possible to achieve the first relative move of the second structure 120 in the transverse direction 151 with respect to the first structure 110.

### (Addendum)

The following technique is disclosed by the present disclosure.

### (Technique 1)

A photovoltaic power generation system including:
a first structure including a plurality of first photoelectric conversion bodies; and
a second structure including at least one second photoelectric conversion body, wherein
the first photoelectric conversion bodies each extend in a first direction as a length direction of the first photoelectric conversion body;
a direction in which the first photoelectric conversion bodies are aligned is a second direction that is orthogonal to the first direction; and
when viewed from a third direction that is orthogonal to both the first direction and the second direction, at least part of the at least one second photoelectric conversion body is formed to overlap with at least part of the first photoelectric conversion bodies.

Technique 1 is suitable for securing electric power generated by a photovoltaic power generation system.

### (Technique 2)

The photovoltaic power generation system according to Technique 1, wherein
the at least one second photoelectric conversion body is a plurality of second photoelectric conversion bodies,
the second photoelectric conversion bodies each extend in the first direction as a length direction of the second photoelectric conversion body, and
a direction in which the second photoelectric conversion bodies are aligned is the second direction.

Technique 2 is suitable for securing electric power generated by a photovoltaic power generation system.

### (Technique 3)

The photovoltaic power generation system according to Technique 1 or 2, wherein
the first structure includes a first substrate supporting the first photoelectric conversion bodies, and
when viewed from the third direction, the first photoelectric conversion bodies are disposed in a region having an area larger than 50% of an area of the first substrate.

Technique 3 is suitable for securing electric power generated by a photovoltaic power generation system.

### (Technique 4)

The photovoltaic power generation system according to any one of Techniques 1 to 3, wherein
the first structure has a first support frame supporting the first photoelectric conversion bodies.

According to Technique 4, a plurality of first photoelectric conversion bodies can be stably supported.

### (Technique 5)

The photovoltaic power generation system according to any one of Techniques 1 to 4, including a third structure including a plurality of third photoelectric conversion bodies, wherein
the third structure is located between the first structure and the second structure along the third direction.

The configuration of Technique 5 is a configuration example.

### (Technique 6)

The photovoltaic power generation system according to any one of Techniques 1 to 5, wherein
the first structure includes a first substrate made of glass or resin, and
the first substrate is located between the second structure and the first photoelectric conversion bodies along the third direction.

According to Technique 6, it is possible to protect the first photoelectric conversion bodies with the first substrate while capturing light into the first photoelectric conversion bodies through the first substrate.

### (Technique 7)

The photovoltaic power generation system according to any one of Techniques 1 to 6, wherein
a dimension of the first photoelectric conversion body in the second direction is larger than 50% of a pitch at which the first photoelectric conversion bodies are aligned in the second direction.

According to Technique 7, it is easy to increase the electric power generated by the first photoelectric conversion bodies.

### (Technique 8)

The photovoltaic power generation system according to any one of Techniques 1 to 7, wherein
the first photoelectric conversion bodies are electrically connected in series.

According to Technique 8, a voltage can be increased easily by power generation.

### (Technique 9)

The photovoltaic power generation system according to any one of Techniques 1 to 8, wherein
the first photoelectric conversion bodies include a perovskite compound.

The configuration of Technique 9 is a configuration example.

### (Technique 10)

The photovoltaic power generation system according to any one of Techniques 1 to 9, including:
a control device; a first DC/DC converter; and a power storage device, wherein
the first photoelectric conversion bodies, the first DC/DC converter, and the power storage device are electrically connected in this order, and
when a ratio of an output voltage from the first DC/DC converter to the power storage device to an input voltage from the first photoelectric conversion bodies to the first DC/DC converter is defined as a first transformation ratio,
the control device controls the first transformation ratio such that the output voltage tracks a target value.

According to Technique 10, it is possible to maintain a high charging efficiency when charging electric power generated by the first photoelectric conversion bodies into a power storage device.

### (Technique 11)

The photovoltaic power generation system according to any one of Techniques 1 to 10, including a guide, wherein
the guide, engaging with at least one of the first structure and the second structure, allows the at least one of the first structure and the second structure to move in the first direction.

The structure of Technique 11 is a configuration example.

### (Technique 12)

The photovoltaic power generation system according to any one of Techniques 1 to 11, wherein
the second structure includes at least one second photoelectric conversion body and a second support frame supporting the at least one second photoelectric conversion body, and
the second support frame includes:
   a pair of frame members extending in the first direction, and
   a frame connector connecting the pair of frame members, where
when a move of the second structure in the first direction relative to the first structure is defined as a relative move,
the relative move achieves a state in which at least one of the first photoelectric conversion bodies overlaps with the frame connector when viewed from the third direction, and
when an average value of a light transmittance in a wavelength range of 400 nm or more and 800 nm or less is defined as a specific light transmittance,
the specific light transmittance of the frame connector in the third direction is higher than the specific light transmittance of the pair of frame members in the third direction.

According to Technique 12, a frame connector is unlikely to hinder incidence of light on the first photoelectric conversion bodies. On the other hand, by hiding wiring or the like behind a pair of frame members, an excellent aesthetic appearance can be achieved. The pair of frame members can correspond to the combination of the fifth frame member 128A and the sixth frame member 128B in the example shown in FIG. 2A. The frame connector can correspond to the seventh frame member 128C or the eighth frame member 128D in the example shown in FIG. 2A.

### (Technique 13)

A photovoltaic power generation system including:
a first structure including a first substrate and a plurality of first photoelectric conversion bodies supported by the first substrate; and
a second structure including at least one light-shielding body, wherein
the first photoelectric conversion bodies each extend in a first direction as a length direction of the first photoelectric conversion body,
a direction in which the first photoelectric conversion bodies are aligned is a second direction that is orthogonal to the first direction, and
when viewed from a third direction that is orthogonal to both the first direction and the second direction, the first photoelectric conversion bodies are disposed in a region having an area larger than 50% of an area of the first substrate.

Technique 13 is suitable for securing electric power generated by a photovoltaic power generation system.

### (Technique 14)

The photovoltaic power generation system according to Technique 13, wherein
the second structure is a window screen or a storm shutter.

The configuration of Technique 14 is a configuration example.

### (Technique 15)

The photovoltaic power generation system according to Technique 13 or 14, wherein
when an average value of a light transmittance in a wavelength range of 400 nm or more and 800 nm or less is defined as a specific light transmittance,
the specific light transmittance of the at least one light-shielding body in the third direction is 90% or less.

The configuration of Technique 15 is a configuration example.

### (Technique 16)

The photovoltaic power generation system according to any one of Techniques 13 to 15, wherein
assuming that
   a first reference area is an entire area of one of the first photoelectric conversion bodies when viewed from the third direction;
   a first overlapping area is an area in which the first photoelectric conversion body overlaps with the at least one light-shielding body when viewed from the third direction;
   a first overlapping rate is a rate of the first overlapping area with respect to the first reference area; and
   a relative move is a move of the second structure in the first direction relative to the first structure,
the relative move for increasing an area in which the first structure overlaps with the second structure when viewed from the third direction from less than 50% to more than 50% of the area of the first structure achieves the following states in an order as listed below:
   a state in which the first overlapping rate of each of the first photoelectric conversion bodies is more than 0% and less than 50%; and
   a state in which the first overlapping rate of each of the first photoelectric conversion bodies is more than 50% and less than 100%.

Technique 16 is suitable for improving reliability of a photovoltaic power generation system.

### (Technique 17)

The photovoltaic power generation system according to any one of Techniques 13 to 16, wherein
assuming that
   a first reference area is an entire area of one of the first photoelectric conversion bodies when viewed from the third direction;
   a first overlapping area is an area in which the first photoelectric conversion body overlaps with the at least one light-shielding body when viewed from the third direction;
   a first overlapping rate is a rate of the first overlapping area with respect to the first reference area; and
   a relative move is a move of the second structure in the first direction relative to the first structure,
the first photoelectric conversion bodies that have undergone the relative move exclude simultaneous presence of a first photoelectric conversion body having the first overlapping rate of 0% and a first photoelectric conversion body having the first overlapping rate of 100%.

Technique 17 is suitable for improving reliability of a photovoltaic power generation system.

### (Technique 18)

The photovoltaic power generation system according to any one of Techniques 13 to 17, including a stopper, wherein
assuming that
   a relative move is a move of the second structure in the first direction relative to the first structure;
   a first reference area is an entire area of one of the first photoelectric conversion bodies when viewed from the third direction;
   a first overlapping area is an area in which the first photoelectric conversion body overlaps with the at least one light-shielding body when viewed from the third direction; and
   a first overlapping rate is a rate of the first overlapping area with respect to the first reference area,
the stopper restricts a relative position of the second structure with respect to the first structure to a first range, the relative position being achievable by the relative move, and
the first photoelectric conversion bodies that have undergone the relative move within the first range exclude simultaneous presence of a first photoelectric conversion body having the first overlapping rate of 0% and a first photoelectric conversion body having the first overlapping rate of 100%.

Technique 18 is suitable for improving the reliability of a photovoltaic power generation system.

In any one of the Techniques 1 to 18, any of the following (a), (b) or (c) may be satisfied:
(a) the first photoelectric conversion body may be a single continued body extending in the first direction as the length direction;
(b) the first photoelectric conversion body is configured with the photoelectric conversion elements aligned in the first direction, and when viewed from the third direction, each photoelectric conversion element overlaps at least partially with the continuous structure, and the continuous structure also forms at least part of a path electrically connecting the photoelectric conversion elements; or
(c) the first photoelectric conversion body is configured with a plurality of photoelectric conversion elements aligned in the first direction, and a plurality of designated structures are aligned in the first direction, and in each designated structure, the photoelectric conversion element is disposed between a first electrode and a second electrode along the third direction, and the designated structures adjacent to each other in the first direction may be divided by a groove.

### INDUSTRIAL APPLICABILITY

The photovoltaic power generation system of the present disclosure can be applied to building materials such as windows.

## Claims

1. A photovoltaic power generation system comprising:
a first structure including a plurality of first photoelectric conversion bodies; and
a second structure including at least one second photoelectric conversion body,
wherein
the first photoelectric conversion bodies each extend in a first direction as a length direction of the first photoelectric conversion body;
a direction in which the first photoelectric conversion bodies are aligned is a second direction that is orthogonal to the first direction; and
when viewed from a third direction that is orthogonal to both the first direction and the second direction, at least part of the at least one second photoelectric conversion body is formed to overlap with at least part of the first photoelectric conversion bodies.

2. The photovoltaic power generation system according to claim 1, wherein
the at least one second photoelectric conversion body is a plurality of second photoelectric conversion bodies,
the second photoelectric conversion bodies each extend in the first direction as a length direction of the second photoelectric conversion bodies, and
a direction in which the second photoelectric conversion bodies are aligned is the second direction.

3. The photovoltaic power generation system according to claim 1, wherein
the first structure includes a first substrate supporting the first photoelectric conversion bodies, and
when viewed from the third direction, the first photoelectric conversion bodies are disposed in a region having an area larger than 50% of an area of the first substrate.

4. The photovoltaic power generation system according to claim 1, wherein
the first structure has a first support frame supporting the first photoelectric conversion bodies.

5. The photovoltaic power generation system according to claim 1, comprising a third structure including a plurality of third photoelectric conversion bodies, wherein
the third structure is located between the first structure and the second structure along the third direction.

6. The photovoltaic power generation system according to claim 1, wherein
the first structure includes a first substrate made of glass or resin, and
the first substrate is located between the second structure and the first photoelectric conversion bodies along the third direction.

7. The photovoltaic power generation system according to claim 1, wherein
a dimension of the first photoelectric conversion body in the second direction is larger than 50% of a pitch at which the first photoelectric conversion bodies are aligned in the second direction.

8. The photovoltaic power generation system according to claim 1, wherein
the first photoelectric conversion bodies are electrically connected in series.

9. The photovoltaic power generation system according to claim 1, wherein
the first photoelectric conversion bodies include a perovskite compound.

10. The photovoltaic power generation system according to claim 1, comprising:
a control device; a first DC/DC converter; and a power storage device, wherein
the first photoelectric conversion bodies, the first DC/DC converter, and the power storage device are electrically connected in this order, and
when a ratio of an output voltage from the first DC/DC converter to the power storage device to an input voltage from the first photoelectric conversion bodies to the first DC/DC converter is defined as a first transformation ratio,
the control device controls the first transformation ratio such that the output voltage tracks a target value.

11. The photovoltaic power generation system according to claim 1, comprising a guide, wherein
the guide, engaging with at least one of the first structure and the second structure, allows the at least one of the first structure and the second structure to move in the first direction.

12. The photovoltaic power generation system according to claim 1, wherein
the second structure includes at least one second photoelectric conversion body and a second support frame supporting the at least one second photoelectric conversion body, and
the second support frame includes:
a pair of frame members extending in the first direction, and
a frame connector connecting the pair of frame members, where
when a move of the second structure in the first direction relative to the first structure is defined as a relative move,
the relative move achieves a state in which at least one of the first photoelectric conversion bodies overlaps with the frame connector when viewed from the third direction, and
when an average value of a light transmittance in a wavelength range of 400 nm or more and 800 nm or less is defined as a specific light transmittance,
the specific light transmittance of the frame connector in the third direction is higher than the specific light transmittance of the pair of frame members in the third direction.

13. A photovoltaic power generation system comprising:
a first structure including a first substrate and a plurality of first photoelectric conversion bodies supported by the first substrate; and
a second structure including at least one light-shielding body, wherein
the first photoelectric conversion bodies each extend in a first direction as a length direction of the first photoelectric conversion body,
a direction in which the first photoelectric conversion bodies are aligned is a second direction that is orthogonal to the first direction, and
when viewed from a third direction that is orthogonal to both the first direction and the second direction, the first photoelectric conversion bodies are disposed in a region having an area larger than 50% of an area of the first substrate.

14. The photovoltaic power generation system according to claim 13, wherein the second structure is a window screen or a storm shutter.

15. The photovoltaic power generation system according to claim 13, wherein
when an average value of a light transmittance in a wavelength range of 400 nm or more and 800 nm or less is defined as a specific light transmittance,
the specific light transmittance of the at least one light-shielding body in the third direction is 90% or less.

16. The photovoltaic power generation system according to claim 13, wherein
assuming that
a first reference area is an entire area of one of the first photoelectric conversion bodies when viewed from the third direction;
a first overlapping area is an area in which the first photoelectric conversion body overlaps with the at least one light-shielding body when viewed from the third direction;
a first overlapping rate is a rate of the first overlapping area with respect to the first reference area; and
a relative move is a move of the second structure in the first direction relative to the first structure,
the relative move for increasing an area in which the first structure overlaps with the second structure when viewed from the third direction from less than 50% to more than 50% of the area of the first structure achieves the following states in an order as listed below:
a state in which the first overlapping rate of each of the first photoelectric conversion bodies is more than 0% and less than 50%; and
a state in which the first overlapping rate of each of the first photoelectric conversion bodies is more than 50% and less than 100%.

17. The photovoltaic power generation system according to claim 13, wherein
assuming that
a first reference area is an entire area of one of the first photoelectric conversion bodies when viewed from the third direction;
a first overlapping area is an area in which the first photoelectric conversion body overlaps with the at least one light-shielding body when viewed from the third direction;
a first overlapping rate is a rate of the first overlapping area with respect to the first reference area; and
a relative move is a move of the second structure in the first direction relative to the first structure,
the first photoelectric conversion bodies that have undergone the relative move exclude simultaneous presence of a first photoelectric conversion body having the first overlapping rate of 0% and a first photoelectric conversion body having the first overlapping rate of 100%.

18. The photovoltaic power generation system according to claim 13, comprising a stopper, wherein
assuming that
a relative move is a move of the second structure in the first direction relative to the first structure;
a first reference area is an entire area of one of the first photoelectric conversion bodies when viewed from the third direction;
a first overlapping area is an area in which the first photoelectric conversion body overlaps with the at least one light-shielding body when viewed from the third direction; and
a first overlapping rate is a rate of the first overlapping area with respect to the first reference area,
the stopper restricts a relative position of the second structure with respect to the first structure to a first range, the relative position being achievable by the relative move, and
the first photoelectric conversion bodies that have undergone the relative move within the first range exclude simultaneous presence of a first photoelectric conversion body having the first overlapping rate of 0% and a first photoelectric conversion body having the first overlapping rate of 100%.
